# EUROPEAN PATENT APPLICATION

(11) **EP 4 459 666 A1**
(43) Date of publication of application: **06.11.2024**
(21) Application number: 22916164.1
(22) Date of filing: 28.12.2022
(51) Int. Cl.: H01L 21/304, C09K 3/18

(54) **COMPOSITION FOR FILM FORMATION AND METHOD FOR PRODUCING SUBSTRATE**

(30) Priority: 28.12.2021 JP 2021213908
(71) Applicant: Central Glass Company, Limited, Ube-shi, Yamaguchi 755-0001 (JP)
(72) Inventor: OKUMURA, Yuzo, Tokyo 101-0054 (JP); TETSUMURA, Mizuki, Tokyo 101-0054 (JP); YOSHIDA, Ayaka, Tokyo 101-0054 (JP); SHIOTA, Saori, Tokyo 101-0054 (JP); TERUI, Yoshiharu, Tokyo 101-0054 (JP)
(74) Representative: Mewburn Ellis LLP
(86) International application number: PCT/JP2022/048486
(87) International publication number: WO 2023/127942

(57) **Abstract**

A composition for film formation according to the present disclosure is used for forming a water-repellent film on at least a part of a surface of a substrate by being supplied to the substrate, in which the surface is covered with a protic liquid, the composition containing a silylating agent which silylates the surface of the substrate, a catalytic compound which promotes a silylation reaction by the silylating agent, and an aprotic solvent, in which a content of the catalytic compound is 1.0% by mass or more with respect to 100% by mass of the composition for film formation.

## Description

### TECHNICAL FIELD

The present disclosure relates to a composition for film formation and a method for manufacturing a substrate.

### BACKGROUND ART

In recent years, there has been a tendency for semiconductor devices to be highly integrated and miniaturized, and the miniaturization and high aspect ratio of resin patterns serving as a mask and inorganic patterns produced by etching have been advanced. However, on the other hand, a problem of so-called pattern collapse has occurred. The pattern collapse is a phenomenon that, in a case where a large number of resin patterns or inorganic patterns are formed in parallel on a substrate, the patterns are brought close to each other so as to be in contact with each other, and in some cases, the patterns are broken or peeled off from a base portion. In a case where such pattern collapse occurs, a desired product cannot be obtained, and thus the yield and reliability of the product are reduced.

It has been known that the pattern collapse occurs when a cleaning liquid is dried in a cleaning treatment after pattern formation due to a surface tension of the cleaning liquid. That is, when the cleaning liquid is removed in the drying process, stress based on the surface tension of the cleaning liquid acts on the patterns, and thus the pattern collapse occurs.

Patent Document 1 discloses a technique of imparting water repellency to an object to be treated (a pattern on a substrate) by surface-treating the object to be treated with a surface treatment agent obtained by mixing a silylating agent and a nitrogen-containing heterocyclic compound not containing a silicon atom, for the purpose of preventing a pattern collapse of an inorganic pattern or a resin pattern provided on the substrate.

In addition, Patent Document 1 discloses that a pattern surface is treated with the surface treatment agent to be hydrophobic and then the pattern surface is cleaned (paragraph 0076), whereby a force acting on the patterns can be reduced during the cleaning and the pattern collapse can be prevented (paragraph 0078). In Examples of Patent Document 1, it is disclosed that the substrate after the surface treatment was cleaned with isopropyl alcohol (2-propanol) and then cleaned with ion-exchanged distilled water.

### RELATED DOCUMENT

### PATENT DOCUMENT

[Patent Document 1] Japanese Unexamined Patent Publication No. 2017-063179

### SUMMARY OF THE INVENTION

### TECHNICAL PROBLEM

Although it has been generally known, the silylating agent reacts with a compound having a hydroxyl group, such as alcohol and water, to cause hydrolysis, and thus a water repellency imparting effect of the silylating agent is reduced.

In view of such circumstances, in Patent Document 1 described above, a method of performing a water repellent treatment on the substrate by cleaning the substrate with a protic liquid such as 2-propanol and water and then exposing the pattern surface in a state in which the liquid remains to the surface treatment agent containing the silylating agent has not been sufficiently studied.

### SOLUTION TO PROBLEM

As a result of further studies, the present inventors have found that a resistance of the surface treatment agent containing the silylating agent to the protic liquid can be stably evaluated in a case where water contact angles of water-repellent films formed by an evaluation solution to which 2-propanol is added and an evaluation solution to which 2-propanol is not added are measured respectively, and both of the water contact angles are compared.

As a result of further intensive studies based on such findings, when a water-repellent film is formed on a surface of a substrate in a state of being covered with a protic liquid due to a liquid film or a liquid droplet of the protic liquid remaining (hereinafter, also referred to as "liquid-attached") by using a composition for film formation which contains a silylating agent and a catalytic compound accelerating a silylation reaction, it was found that, by appropriately adjusting a content of the catalytic compound in the composition for film formation, it is possible to suppress a decrease in water contact angle of the water-repellent film and it is possible to realize a water-repellent film having an excellent water repellency imparting effect, thereby completing the present invention.

According to one aspect of the present disclosure, the following composition for film formation and method for manufacturing a substrate are provided.

1. A composition for film formation, which is used for forming a water-repellent film on at least a part of a surface of a substrate by being supplied to the substrate, in which the surface is covered with a protic liquid, the composition containing:
   a silylating agent which silylates the surface of the substrate;
   a catalytic compound which promotes a silylation reaction by the silylating agent; and
   an aprotic solvent,
   in which a content of the catalytic compound is 1.0% by mass or more with respect to 100% by mass of the composition for film formation.
2. The composition for film formation according to 1.,
   in which a water contact angle CA2 in a case of adding 2% by mass of 2-propanol, which is measured by the following coupon test, is 80° or more,
   (procedure of coupon test)
   a silicon wafer having no concave-convex pattern on a surface and having a silicon oxide film with a thickness of 1 um on the surface is cut to prepare a coupon consisting of a silicon substrate having dimensions of a length of 4 cm, a width of 1 cm, and a thickness of 0.75 mm,
   the coupon is immersed in 1% by mass hydrofluoric acid at a room temperature, immersed in water four times at the room temperature, immersed in 2-propanol two times at the room temperature, and immersed in propylene glycol monomethyl ether acetate two times at the room temperature to be cleaned,
   an evaluation solution obtained by mixing the composition for film formation and 2-propanol in an amount of 2% by mass or 5% by mass with respect to 100% by mass of the composition for film formation in terms of mass is prepared, and the cleaned coupon is immersed in the evaluation solution at the room temperature,
   the coupon extracted from the evaluation solution is cleaned by being immersed in 2-propanol three times at the room temperature, and a surface of the coupon is dried with nitrogen gas,
   in a state in which the dried coupon is placed on a horizontal plane, 2 µl of pure water is placed on the surface of the coupon on which the silicon oxide film has formed, at the room temperature, and a water contact angle (°) is measured in accordance with JIS R 3257:1999, and
   a water contact angle of the evaluation solution in which the 2% by mass or 5% by mass of 2-propanol has been added is indicated as CA2 or CA5, respectively.
3. The composition for film formation according to 2.,
   in which a water contact angle CA5 in a case of adding 5% by mass of 2-propanol, which is measured by the above coupon test, is 80° or more.
4. The composition for film formation according to any one of 1. to 3.,
   in which, in a case where, with respect to 100% by mass of the composition for film formation, a content of the silylating agent is denoted by X in terms of mass and a content of the catalytic compound is denoted by Y in terms of mass, X and Y satisfy 1.0 < X/Y ≤ 20.
5. The composition for film formation according to any one of 1. to 4.,
   in which a content of the catalytic compound is 30% by mass or less with respect to 100% by mass of the composition for film formation.
6. The composition for film formation according to any one of 1. to 5.,
   in which the silylating agent contains a silicon compound represented by General Formula [1],

      R¹ₐSi(H)_{b}X_{4-a-b} [1]
   (in General Formula [1], R¹'s are each independently an organic group including a hydrocarbon group having 1 to 18 carbon atoms, in which a part or all of hydrogen atoms may be replaced with fluorine atoms, X's are each independently a monovalent organic group in which an atom bonded to an Si atom is nitrogen, oxygen, carbon, or halogen, a is an integer of 1 to 3, b is an integer of 0 to 2, and a sum of a and b is 1 to 3).
7. The composition for film formation according to any one of 1. to 6.,
   in which the catalytic compound includes one or two or more selected from the group consisting of trimethylsilyl trifluoroacetate, trimethylsilyl trifluoromethanesulfonate, dimethylsilyl trifluoroacetate, dimethylsilyl trifluoromethanesulfonate, butyldimethylsilyl trifluoroacetate, butyldimethylsilyl trifluoromethanesulfonate, hexyldimethylsilyl trifluoroacetate, hexyldimethylsilyl trifluoromethanesulfonate, octyldimethylsilyl trifluoroacetate, octyldimethylsilyl trifluoromethanesulfonate, decyldimethylsilyl trifluoroacetate, and decyldimethylsilyl trifluoromethanesulfonate.
8. The composition for film formation according to any one of 1. to 6.,
   in which the catalytic compound includes one or two or more selected from the group consisting of trimethylsilyl trifluoroacetate, dimethylsilyl trifluoroacetate, butyldimethylsilyl trifluoroacetate, hexyldimethylsilyl trifluoroacetate, octyldimethylsilyl trifluoroacetate, and decyldimethylsilyl trifluoroacetate.
9. The composition for film formation according to any one of 1. to 6.,
   in which the catalytic compound includes one or two or more selected from the group consisting of trimethylsilyl trifluoromethanesulfonate, dimethylsilyl trifluoromethanesulfonate, butyldimethylsilyl trifluoromethanesulfonate, hexyldimethylsilyl trifluoromethanesulfonate, octyldimethylsilyl trifluoromethanesulfonate, and decyldimethylsilyl trifluoromethanesulfonate.
10. The composition for film formation according to any one of 1. to 6.,
   in which the catalytic compound includes one or two or more selected from the group consisting of a compound having a guanidine skeleton, a nitrogen-containing heterocyclic compound containing no silicon atom, and a silylated heterocyclic compound.
11. The composition for film formation according to any one of 1. to 10.,
   in which a total content of the silylating agent and the catalytic compound contained in 100% by mass of the composition for film formation is 8% by mass or more.
12. A method for manufacturing a substrate, including:
   a step of preparing a substrate having a concave-convex pattern on a surface;
   a step of supplying a protic liquid to the surface of the substrate; and
   a step of supplying a composition for film formation to the surface holding the protic liquid to form a water-repellent film on at least a part of the surface,
   in which the composition for film formation contains a silylating agent which silylates the surface of the substrate, a catalytic compound which promotes a silylation reaction by the silylating agent, and an aprotic solvent, and
   a content of the catalytic compound is 1.0% by mass or more with respect to 100% by mass of the composition for film formation.
13. The method for manufacturing a substrate according to 12.,
   in which the step of forming the water-repellent film includes a step of forming a mixed liquid obtained by mixing the protic liquid held on the substrate and the composition for film formation supplied to the substrate.

### ADVANTAGEOUS EFFECTS OF INVENTION

According to the present disclosure, there is provided a composition for film formation having an excellent water repellency imparting effect even in a case of coming into contact with or being mixed with a protic liquid, and a method for manufacturing a substrate using the composition.

### BRIEF DESCRIPTION OF THE DRAWINGS

Fig. 1 is a perspective view schematically showing an example of a configuration of a substrate on a main surface side.
Fig. 2 is a cross-sectional view schematically showing a part of a cross section of the substrate in Fig. 1 taken along a line A-A.
Fig. 3 is a cross-sectional view of a step schematically showing an example of a process of manufacturing a substrate.
Fig. 4 is a cross-sectional view of a step schematically showing the example of the process of manufacturing a substrate.

### DESCRIPTION OF EMBODIMENTS

Hereinafter, embodiments of the present disclosure will be described with reference to the drawings. In all drawings, the same components are designated by the same reference numerals, and description thereof will not be repeated. In addition, the drawings are schematic views and do not match the actual dimensional ratio.

An outline of the composition for film formation according to the present embodiment will be described.

The composition for film formation according to the present embodiment is a chemical solution used for forming a water-repellent film on at least a part of a surface of a substrate by being supplied to the substrate whose surface is covered with a protic liquid.

The composition for film formation contains a silylating agent which silylates the surface of the substrate, a catalytic compound which promotes a silylation reaction by the silylating agent, and an aprotic solvent, and the composition for film formation is configured such that a content of the catalytic compound is 1.0% by mass or more with respect to 100% by mass of the composition for film formation.

As a result of studies by the present inventors, it has been found that, in a case where a chemical solution containing a silylating agent is supplied to a dry surface of a substrate to perform a water-repellent treatment and a case where the chemical solution is supplied to a surface of a substrate, on which a protic liquid such as 2-propanol has been liquid-attached, to perform a water-repellent treatment, when comparing water contact angles of water-repellent films formed on the surface of the substrate after the treatment, the water contact angle of the latter case is smaller than that of the former case by several degrees or more.

In a case where the above description is considered in terms of the actual process of manufacturing a semiconductor substrate, the protic liquid is supplied to the surface of the substrate in a cleaning step, and then the chemical solution is supplied to the surface of the substrate, on which the protic liquid has been liquid-attached, as in the latter case.

In addition, with the recent trend of pattern miniaturization and high aspect ratio, substrate enlargement, and the like, there is a demand for a chemical solution having a more excellent water repellency imparting effect for suppressing pattern collapse of the substrate.

As a result of intensive studies based on the above, the present inventors have examined the water repellency imparting effect in "liquid in a mixed state" of the chemical solution and the protic liquid when the protic liquid is supplied to the liquid-attached surface of the substrate, as in the latter case. However, it is difficult to recover the "liquid in a mixed state" in the actual process.

Therefore, instead of the above, using a coupon test described later, a mixed solution of the chemical solution and 2-propanol which is the protic liquid is treated as the "liquid in a mixed state" to measure the water contact angle by surface-treating the substrate with the mixed solution, and an example of the water repellency imparting effect is evaluated.

As a result, it has been found that, in a case where the 2-propanol is added at a low concentration, the decrease in water contact angle can be suppressed by setting the content of the catalytic compound to be equal to or more than a predetermined level in the chemical solution (composition for film formation) containing the silylating agent and the catalytic compound which promotes the silylation reaction, and the decrease in water contact angle can be suppressed at a certain level. Furthermore, it has been found that the decrease in water contact angle can be suppressed even in a case of a high concentration in which the concentration of 2-propanol is increased to a predetermined concentration by appropriately selecting the type of the catalytic compound and the content of the silylating agent.

In addition, an example of the water repellency imparting effect is evaluated using a test in a form closer to the actual process. That is, a test is performed in which the water contact angle is measured at predetermined intervals from a center of the substrate to an edge of the substrate for the water-repellent film formed on the surface of the substrate by supplying the chemical solution and performing a spin treatment, after supplying the protic liquid and performing a spin treatment at the center of the surface of the wafer (substrate). As a result, by setting the content of the catalytic compound to be equal to or more than a predetermined value in the chemical solution containing the silylating agent and the catalytic compound which promotes the silylation reaction (composition for film formation), it has been found that a difference between the maximum value and the minimum value of the water contact angle can be reduced and that uniformity of the water contact angle in the substrate plane can be improved at a certain level.

By using the composition for film formation according to the present embodiment, it is possible to suppress an increase in variation in the water contact angle in the substrate plane (difference between the maximum value and the minimum value of the water contact angle in a region from the center of the substrate to the edge of the substrate), which may be caused by mixing and substitution with the protic liquid liquid-attached on the surface of the substrate. In addition, it can be said that in-plane uniformity of the water contact angle is high in a case where the above-described variation is small.

In addition, by using the composition for film formation according to the present embodiment, it is possible to suppress a decrease in water contact angle in a case where the concentration of the protic liquid is increased, in addition to the above-described in-plane uniformity of the water contact angle.

By using the composition for film formation having such an excellent water repellency imparting effect, it is possible to enhance the effect of suppressing pattern collapse of the substrate.

The lower limit of the content of the catalytic compound is 1.0% by mass or more, preferably 1.5% by mass or more, more preferably 2.0% by mass or more, and still more preferably 2.5% by mass or more with respect to 100% by mass of the composition for film formation. As a result, the water repellency imparting effect of the water-repellent film formed of the composition for film formation can be improved even in a case where the composition for film formation comes into contact with or is mixed with the protic liquid.

The upper limit of the content of the catalytic compound may be, for example, 30% by mass or less, preferably 20% by mass or less and more preferably 15% by mass or less with respect to 100% by mass of the composition for film formation. As a result, it is easy to suppress a change in components, which occurs during storage of the composition for film formation.

A lower limit of a concentration of the silylating agent may be, for example, 1% by mass or more, preferably 2% by mass or more, more preferably 5% by mass or more, and still more preferably 7% by mass or more with respect to 100% by mass of the composition for film formation. As a result, it is possible to further suppress the decrease in water repellency imparting effect even after the composition for film formation comes into contact with the protic liquid. In addition, an upper limit thereof may be, for example, 90% by mass or less, preferably 50% by mass or less and more preferably 30% by mass or less. As a result, the substitution of the protic liquid and the composition for film formation, which are liquid-attached on the surface of the substrate, can be easily progressed.

A lower limit of the total content of the silylating agent and the catalytic compound contained in 100% by mass of the composition for film formation may be, for example, 8% by mass or more, preferably 9% by mass or more and more preferably 10% by mass or more. As a result, a water contact angle CA5 in a case of adding 5% by mass of 2-propanol, which is measured by the above-described coupon test, is easily improved.

An upper limit of the above-described total content of the silylating agent and the catalytic compound may be, for example, 95% by mass or less, preferably 50% by mass or less and more preferably 30% by mass or less. As a result, the substitution of the protic liquid and the composition for film formation, which are liquid-attached on the surface of the substrate, can be easily progressed.

In a case where, with respect to 100% by mass of the composition for film formation, a content of the silylating agent is denoted by X in terms of mass and a content of the catalytic compound is denoted by Y in terms of mass, the composition for film formation may be configured such that X and Y satisfy 1.0 < X/Y ≤ 20.

The lower limit of X/Y may be, for example, more than 1.0, preferably 2.0 or more and more preferably 2.5 or more. In a case where X/Y is more than 1.0, even when the supply time is shortened at the same flow rate for the surface treatment, it is easy to suppress the deterioration of the in-plane uniformity of the water contact angle. In a case where X/Y is 2.0 or more or 2.5 or more, there is a tendency that the decrease in water contact angle CA5 in a case of adding 5% by mass of 2-propanol is easily reduced.

The upper limit of X/Y may be, for example, 20 or less, preferably 14 or less and more preferably 10 or less. As a result, it is easy to suppress the decrease in water contact angle even in a case where the supply time is shortened at the same flow rate for the surface treatment.

A water contact angle CA2 in a case of adding 2% by mass of 2-propanol, which is measured by the following coupon test, is added may be, for example, 80° or more, preferably 82° or more and more preferably 85° or more. As a result, it is easy to realize a composition for film formation having an excellent water repellency imparting effect in a case where the composition for film formation comes into contact with a relatively small amount of the protic liquid on the surface of the substrate or in a case where the protic liquid is present in the mixed solution at a relatively low concentration after mixing with the protic liquid.

The water contact angle CA5 in a case of adding 5% by mass of 2-propanol, which is measured by the following coupon test, is added may be, for example, 80° or more, preferably 82° or more and more preferably 85° or more. As a result, it is easy to realize a composition for film formation having an excellent water repellency imparting effect in a case where the composition for film formation comes into contact with a larger amount of the protic liquid than the CA2 on the surface of the substrate or in a case where the protic liquid is present in the mixed solution at a higher concentration than the CA2 after mixing with the protic liquid.

Both of the CA2 and the CA5 are preferably 80° or more, and may be more preferably 85° or more. As a result, it is easy to realize a composition for film formation having an excellent water repellency imparting effect in a case where the composition for film formation comes into contact with a relatively small amount of the protic liquid on the surface of the substrate or in a case where the protic liquid is present in the mixed solution at a relatively low concentration after mixing with the protic liquid.

In addition, it is more preferable that CA5 is 80° or more and CA2 - CA5 is 4° or less, and it is still more preferable that CA2 - CA5 is 3° or less. As a result, even in a case where the amount of the protic liquid in contact with the surface of the substrate or the amount of the protic liquid to be mixed increases by a small amount of more than 5% by mass, the significant decrease in water repellency imparting effect is easily suppressed.

### (Procedure of coupon test)

A silicon wafer having no concave-convex pattern on a surface and having a silicon oxide film with a thickness of 1 um on the surface is cut to prepare a coupon consisting of a silicon substrate having dimensions of a length of 4 cm, a width of 1 cm, and a thickness of 0.75 mm. The following test is performed by regarding the surface on which the above-described silicon oxide film is formed as a main surface.

The above-described coupon is immersed in 1% by mass hydrofluoric acid at room temperature, immersed in water four times at room temperature, immersed in 2-propanol two times at room temperature, and then immersed in propylene glycol monomethyl ether acetate two times at room temperature to be cleaned. In the present specification, the "room temperature" refers to 23°C ± 2°C.

An evaluation solution obtained by mixing the composition for film formation and 2-propanol in an amount of 2% by mass or 5% by mass with respect to 100% by mass of the composition for film formation in terms of mass is prepared, and the cleaned coupon is immersed in the evaluation solution at room temperature. An immersion time in the evaluation solution is set to 20 seconds.

The coupon extracted from the above-described evaluation solution is cleaned by being immersed in 2-propanol three times at the room temperature, and a surface of the coupon is dried with nitrogen gas.

In a state in which the dried coupon is placed on a horizontal plane, 2 µl of pure water is placed on the surface of the coupon on which the silicon oxide film has formed, at room temperature, and a water contact angle (°) is measured in accordance with JIS R 3257:1999.

A water contact angle of the evaluation solution in which the 2% by mass or 5% by mass of 2-propanol has been added is indicated as CA2 or CA5, respectively.

### (Method for manufacturing substrate)

Hereinafter, a method for manufacturing a substrate using the composition for film formation according to the present embodiment will be described.

An example of the above-described method for manufacturing a substrate includes a preparation step of preparing a substrate having a concave-convex pattern on a surface, a holding step of supplying a protic liquid to the surface of the substrate, and a surface treatment step of supplying a composition for film formation to the surface holding the protic liquid to form a water-repellent film on at least a part of the surface.

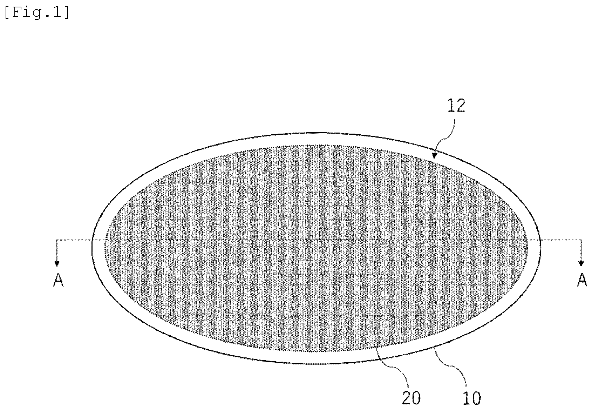

Each step will be described with reference to Figs. 1 to 4, but is not limited thereto.

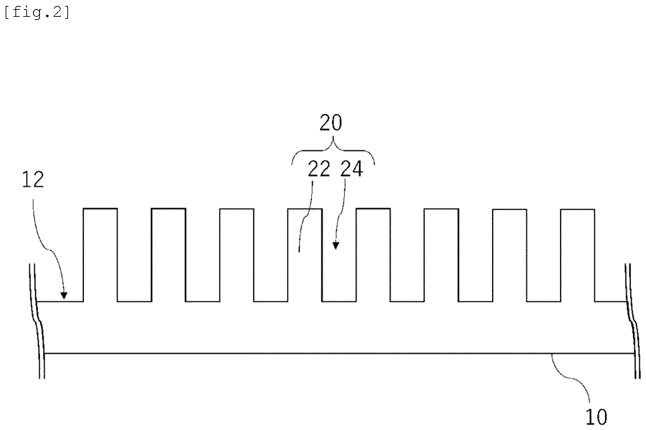

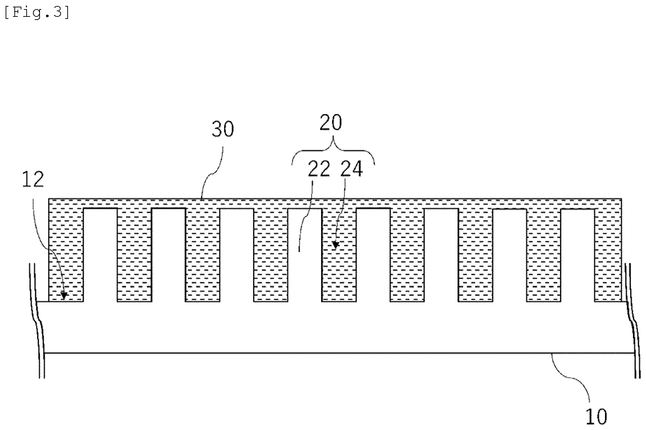

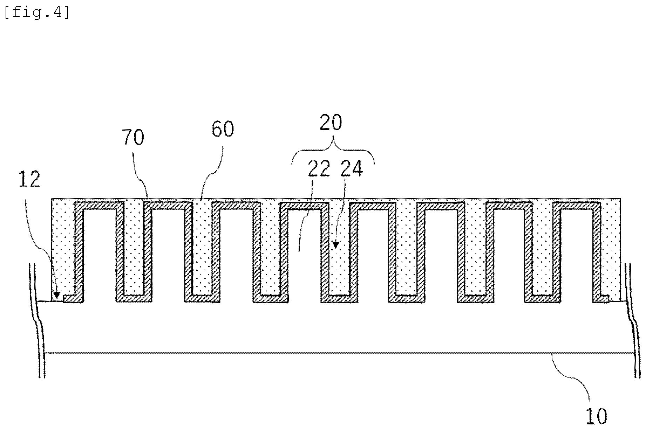

Fig. 1 is a schematic perspective view of a substrate 10 on a main surface 12 side. Fig. 2 is a partial schematic view of a cross section of the substrate 10 in Fig. 1 taken along a line A-A. Figs. 3 and 4 are schematic cross-sectional views showing a manufacturing process. The above-described "main surface" refers to a substrate surface on a side having the concave-convex pattern.

First, in the preparation step, as shown in Figs. 1 and 2, the substrate 10 on which a pattern (concave-convex structure 20) is formed on the main surface 12 is prepared.

In the above-described preparation step of the substrate 10, the following method, which is an example of a method of forming the concave-convex structure 20 on the surface of the substrate 10, may be used.

First, a resist is applied to a surface of a wafer, and then the resist is exposed through a resist mask. Thereafter, by removing the exposed resist or the unexposed resist, a resist having a desired concave-convex pattern is produced. In addition, the resist having a concave-convex pattern can also be obtained by pressing a mold having a pattern against the resist. Next, the wafer is etched. At this time, the substrate surface corresponding to the concave portion of the resist pattern is selectively etched. Finally, in a case of peeling off the resist, a wafer (substrate 10) having the concave-convex structure 20 on the surface is obtained.

As the substrate 10, a general semiconductor substrate is used, but the wafer on which the concave-convex structure 20 is formed and the material of the concave-convex structure 20 are not particularly limited.

As the material of the wafer, a variety of wafers such as a silicon wafer, a silicon carbide wafer, a wafer composed of a plurality of components containing a silicon atom, a sapphire wafer, and a variety of compound semiconductor wafers can be used.

As the material of the concave-convex structure 20, one or two or more kinds selected from the group consisting of Si, Ti, Ge, W, Ru, and oxides, nitrides, nitrogen oxides, carbonitrides, or carbide oxides, which include one or more kinds of these elements, may be included. For example, as the material of the concave-convex structure 20, silicon-based materials such as silicon oxide, silicon nitride, silicon carbide, polycrystalline silicon, single crystalline silicon, silicon germanium, and low-k material; metal-based materials such as titanium nitride, tungsten, ruthenium, tantalum nitride, and tin; materials obtained by combining these materials; resist (photoresist) materials; and the like can be used. Examples of the low-k material include SiON, SiCN, SiCO, SiCOH, and SiOCN. The formulation of the low-k material is only typically described, and the stoichiometric ratio thereof may not be the integer ratio as described above. Specifically, in a case of SiON, Si:O:N is not limited to 1:1:1.

In addition, it is desirable that a region where the water-repellent film is to be formed, particularly the surface of the concave-convex structure 20, has a material in which the silylating agent easily forms a bond or a material in which the silylating agent is easily adsorbed.

As the material in which the silylating agent easily forms a bond or the material in which the silylating agent is easily adsorbed, a silicon-based material having an Si atom is preferable, and examples thereof include at least one of silicon oxide, silicon nitride, silicon carbide, polycrystalline silicon, single crystalline silicon, silicon germanium, and a low-k material, and silicon oxide is particularly preferable. In addition, the above-described silicon-based material may contain one or two or more other elements (C, N, other metal elements, and the like) as necessary.

In addition, it is also preferable that the surface of the concave-convex structure 20 has an Si-OH group, and a region having an Si-OH group and a region not having an Si-OH group may be mixed. The above-described material containing the silicon element may be surface-treated to form the Si-OH group on the surface.

The substrate 10 has a pattern formation region where the pattern (concave-convex structure 20) is formed on the main surface 12, and may have a pattern non-formation region where the pattern is not formed around the pattern formation region as necessary.

In the pattern formation region and/or between the pattern formation region and the pattern non-formation region, one or two or more cut regions for dicing may be formed.

In the substrate 10, a notch portion may be formed in a part of the peripheral portion. For the purpose of positioning in an exposure apparatus or the like, the notch portion may be formed with a straight cut called as an orientation flat, which indicates a direction of a crystal axis, or a V-shaped cut called as a notch.

A bevel region may be formed in at least a part of an end portion of the substrate 10. The substrate 10 in the bevel region has at least an inclined surface (bevel) on the main surface 12 side, and specifically, a top edge, an upper bevel, a front shoulder, an end surface, and a lower bevel may be continuously formed.

The pattern formation region is a region in which one or two or more concave-convex structures 20 are formed in a case of being viewed from a direction perpendicular to the main surface 12, that is, in a top view. The pattern formation region may include an element formation region in which one or two or more semiconductor elements are formed.

For example, the concave-convex structure 20 may be constituted of a three-dimensional structure having one or two or more structures arranged along a vertical direction of the main surface 12 and/or of one or two or more structures arranged along a horizontal direction orthogonal to the vertical direction. As an example of such a three-dimensional structure, at least a part of a logic device or a memory device may be configured, and examples thereof include FinFETs, nanowire FETs, nanosheet FETs, other multigate FETs, and three-dimensional memory cells.

A pattern dimension of the concave-convex structure 20 is defined as at least one dimension in a width direction of an in-plane direction of the main surface 12 and/or at least one dimension in a height direction of a direction perpendicular to the main surface 12.

At least one or more pattern dimensions of the width and the height in the cross-sectional structure (in a thickness direction of the substrate) of the pattern of the concave-convex structure 20, or at least one or more pattern dimensions of the width (length in an X-axis direction), the height (length in a Y-axis direction), and the depth (length in a Z-axis direction) in the three-dimensional structure (three-dimensional coordinates of XYZ) in the pattern of the concave-convex structure 20 may be, for example, 30 nm or less, 20 nm or less, or 10 nm or less. These may be a spacing between the patterns. Even in a case where the substrate 10 having such a fine concave-convex structure 20 used, the composition for film formation according to the present embodiment can be applied.

Such a composition for film formation is suitable, for example, for a surface treatment of the substrate 10 having the concave-convex structure 20 having a pattern dimension of 30 nm or less, preferably 20 nm or less.

An aspect ratio of a convex portion 22 may be, for example, 3 or more, 5 or more, or 10 or more. Even in the concave-convex structure 20 which has the convex portion 22 having a fragile structure, the pattern collapse can be suppressed.

On the other hand, the aspect ratio of the convex portion 22 is not particularly limited, but may be 100 or less.

The aspect ratio of the convex portion 22 is represented by a value obtained dividing the height of the convex portion 22 by the width of the convex portion 22.

Subsequently, in the holding step, as shown in Fig. 3, a protic liquid 30 is supplied to the main surface 12 of the substrate 10.

An example of the holding step is carried out by a cleaning step described later using the protic liquid 30. Specifically, the protic liquid 30 may be used in the cleaning step carried out immediately before the surface treatment step. In addition, the cleaning step may be performed a plurality of times, and the cleaning step using the protic liquid 30 may be performed after a cleaning step using a cleaning liquid other than the protic liquid 30.

It is sufficient that the protic liquid 30 is held on the main surface 12 of the substrate 10 immediately before the subsequent surface treatment step, and for example, the protic liquid 30 may be held so as to fill a part or all of concave portions 24 of the concave-convex structure 20.

The protic liquid 30 means a liquid containing a group in which a hydrogen atom is bonded to an oxygen atom or a nitrogen atom, such as a hydroxyl group and an amino group. Specific examples thereof include water, alcohol, organic acid, inorganic acid, organic base, inorganic base, and mixtures thereof.

The above-described cleaning step is performed for the purpose of removing impurities or unnecessary residues from the main surface 12 of the substrate 10 using the cleaning liquid or for the purpose of substituting the liquid in contact with the main surface 12 with the cleaning liquid. In addition, the cleaning step may be performed once or twice or more before the surface treatment step, and other steps may be included between the plurality of cleaning steps and between the cleaning step and the surface treatment step.

Examples of the cleaning liquid include water, an organic solvent, a mixture thereof, and a mixture thereof with at least one of an acid, an alkali, a surfactant, and an oxidizing agent. In addition, the above-described protic liquid 30 may be used.

Specific examples thereof include water, an aqueous solution of ammonium hydroxide, an aqueous solution of tetramethylammonium, an aqueous solution of hydrochloric acid, an aqueous solution of hydrogen peroxide, an aqueous solution of sulfuric acid, and a mixture of an organic solvent and water. These aqueous cleaning liquids may be used alone or in combination of two or more kinds thereof.

In addition, specific examples of the organic solvent include hydrocarbons, esters, ethers, ketones, halogen atom-containing solvents, sulfoxide-based solvents, alcohols, derivatives of polyhydric alcohol, and nitrogen atom-containing solvents. Among these, as the organic solvent, it is preferable to use at least one selected from an alcohol having 3 or less carbon atoms, such as methanol, 1-propanol, and 2-propanol (isopropanol).

Subsequently, in the surface treatment step, as shown in Fig. 4, the composition 60 for film formation according to the present embodiment comes into contact with the main surface 12 (surface) of the substrate 10 holding the protic liquid 30 to form a water-repellent film 70 on at least a part of the main surface 12 of the substrate 10.

The supply of the composition 60 for film formation is performed in a state in which the protic liquid 30 is held on the main surface 12. That is, the surface treatment step is performed before the surface of the concave-convex structure 20 on the main surface 12 of the substrate 10 is in a dry state by substituting the protic liquid 30 with the composition 60 for film formation.

At this time, it is considered that the protic liquid 30 on the main surface 12 is substituted so as to be extruded to the composition 60 for film formation, but at least a part of the held protic liquid 30 and the supplied composition 60 for film formation are mixed to form a mixed liquid. In one of the preferred embodiments of the present invention, even in a case where the above-described mixed liquid is produced, it is possible to maintain the water repellency imparting effect. In addition, the above-described mixed liquid is preferably 100:5 or less and more preferably 100:2 or less in terms of mass ratio of composition for film formation:protic liquid.

It is preferable to supply the composition 60 for film formation, which is a liquid, to the concave-convex structure 20 formed on the surface of the substrate 10. In this case, the composition for film formation may be supplied so as to fill a part or all of the concave portions 24 of the concave-convex structure 20.

As a method of supplying the composition 60 for film formation, a known method can be used, and for example, a single wafer method typified by a spin method (spin coating method) in which a composition is supplied near a center of rotation while wafers are held one by one substantially horizontally and rotated to replace the protic liquid 30 held in a concave-convex pattern of the wafer, so that the composition is filled, is preferable, and a batch method or the like in which a plurality of wafers are immersed in a composition tank to replace the protic liquid 30 held in the concave-convex pattern of the wafers, so that the composition is filled, may be used. In addition, the composition 60 for film formation can also be substituted for the protic liquid 30 held in the concave-convex pattern of the wafer by, for example, vaporizing the composition 60 for film formation and supplying the vapor to the surface to be treated of the wafer to coagulate the composition 60 for film formation on the surface to be treated to be in a liquid state.

As necessary, the formation of the water-repellent film 70 may be promoted by adopting a known method such as a heating treatment, a decompression treatment, and a drying treatment to the composition 60 for film formation on the main surface 12.

Subsequently, as necessary, the main surface 12 on which the water-repellent film 70 has been formed may be brought into contact with a cleaning liquid (post-cleaning step).

As the cleaning liquid at this time, those exemplified as the cleaning liquid used in the above-described cleaning step can be used.

In the preparation of the composition 60 for film formation in the above-described surface treatment step, it is preferable that the composition 60 for film formation is prepared in a dry atmosphere or an inert atmosphere in order to make the water repellency imparting effect of the composition 60 for film formation favorable. In addition, in the supplying of the composition 60 for film formation to the substrate 10 in the surface treatment step, it is preferable that the inside of the manufacturing apparatus is set in a drying atmosphere or an inert atmosphere, or a drying gas or an inert gas is supplied to the main surface 12 of the substrate 10 or the vicinity of the main surface 12. In addition, the same operation may be performed on all the steps of the surface treatment step, the above-described holding step and cleaning step, and a post-cleaning step, a drying step, a removing step, and the like described later.

The composition 60 for film formation, which is one of the suitable embodiments in the present disclosure, has an excellent water repellency imparting effect even in a case of coming into contact with the protic liquid. Therefore, the composition 60 for film formation may have a relaxed standard for a drying atmosphere, an inert atmosphere, or moisture included in the drying atmosphere, the inert atmosphere, the dry gas, or the inert gas to the extent that the performance of the composition 60 for film formation is not significantly impaired.

The post-cleaning step may be performed once or twice or more after the surface treatment step. Other steps may be included between the plurality of post-cleaning steps and between the surface treatment step and the post-cleaning step.

Subsequently, a drying step of drying the main surface 12 of the substrate 10 may be performed as necessary.

By the drying step, the liquid existing on the main surface 12 of the substrate 10 can be removed.

As a drying method, for example, known methods such as a spin drying method, an IPA (2-propanol) steam drying, a Marangoni drying, a heat drying, a warm air drying, and a vacuum drying may be used.

The drying step may be performed once or twice or more, and for example, may be performed after the surface treatment step or after the post-cleaning step. The drying step and the post-cleaning step may be alternately repeated.

Subsequently, the water-repellent film 70 on the main surface 12 of the substrate 10 may be removed (removing step).

Examples of a removing method include heating, UV irradiation, ozone exposure, plasma irradiation, and corona discharge. In addition, a treatment with a concentrated fluid such as a supercritical fluid (which may include an acid, a base, or an oxidizing agent) or a steam treatment may be performed. These may be used alone or in combination of two or more kinds thereof. These treatments may be performed under atmospheric pressure or reduced pressure.

In this manner, the semiconductor substrate (substrate 10) is obtained by the method for manufacturing a substrate using the composition for film formation according to the present embodiment.

The manufacturing method shown in Fig. 3 targets a wafer pattern, but the present disclosure is not limited thereto.

Examples of the method for manufacturing a semiconductor substrate include a method of performing a pattern formation, a cleaning step including a holding step, a surface treatment step with a composition for film formation, a post-cleaning step, a drying step, a removal of a water-repellent film, and the like on the main surface of the semiconductor substrate.

In the method for manufacturing a substrate according to the present embodiment, targeting the resist pattern, it is also possible to suppress a resist pattern from collapsing by using the composition for film formation according to the present disclosure in the cleaning and drying step of the resist pattern.

Although the above-described surface treatment step has been described as a manufacturing method performed after the cleaning step, the present invention is not limited thereto, and the surface treatment step may be performed after various treatments performed on the concave-convex structure 20.

As the method for manufacturing a substrate, one or a combination of two or more known treatments may be used in addition to the above-described steps. For example, after the above-described removing step, a surface treatment such as a plasma treatment may be performed.

The composition for film formation of still another aspect can be used to form a selective protective film.

The selective protective film refers to a protective film that selectively protects a surface of a specific material in a substrate having a plurality of materials on the surface. Examples thereof include a case where the concave-convex structure 20 is formed of a plurality of types of materials as described above and a case where the materials are different between the concave-convex structure 20 and the pattern non-formation region. In addition, in the above-described pattern non-formation region, regions having different materials may be present. After forming the selective protective film, a region where the protective film is formed may be selectively subjected to an etching treatment or a cleaning treatment in the non-protected region, or a selective film may be formed.

It is sufficient that the above-described "selective protection" refers to a case where a water contact angle on a first surface and a water contact angle on a second surface are different from each other, and it is preferable that the water-repellent film 70 is formed on the first surface and the water-repellent film 70 is not formed on the second surface.

The combination of the first surface and the second surface may be, for example, a combination in which the first surface is a surface containing Si and the second surface is a surface not containing Si and containing a metal. In addition, in a case where the selective protective film is formed on the substrate having the concave-convex structure 20, it is preferable that the surface of the concave-convex structure 20 is defined as the first surface, because it is possible to suppress the pattern collapse.

As the above-described first surface, it is preferable to use at least one selected from the group consisting of silicon oxide, silicon nitride, silicon carbide, polycrystalline silicon, single crystalline silicon, silicon germanium, and a low-k material.

As the above-described second surface, a metal material containing one or two or more of W, Co, Ti, Ta, Cu, Ge, and Ru, or an oxide, a nitride, a nitrogen oxide, a carbide oxide, or the like of these metal materials is preferable.

Hereinafter, each component of the composition for film formation used in the above-described method for manufacturing a substrate will be described.

### (Silylating agent)

The composition for film formation according to the present embodiment contains a silylating agent.

As the above-described silylating agent, a known silylating agent can be used. As the silylating agent, for example, a silicon compound represented by General Formula [1] may be used. These may be used alone or in combination of two or more kinds thereof.

R¹ₐSi(H)_{b}X_{4-a-b} [1]

In General Formula [1], R¹'s are each independently an organic group including a hydrocarbon group having 1 to 18 carbon atoms, in which a part or all of hydrogen atoms may be replaced with fluorine atoms, X's are each independently a monovalent organic group in which an atom bonded to an Si atom is nitrogen, oxygen, carbon, or halogen, a is an integer of 1 to 3, b is an integer of 0 to 2, and a sum of a and b is 1 to 3.

R¹ in General Formula [1] may include not only a hydrogen atom, a carbon atom, a nitrogen atom, an oxygen atom, and a fluorine atom, but also a silicon atom, a sulfur atom, and a halogen atom other than fluorine.

In addition, R¹ in General Formula [1] may include an unsaturated bond, an aromatic ring, or a cyclic structure.

Examples of R¹ in General Formula [1] each independently include at least one group selected from CₑH_{2e + 1} (e = 1 to 18) and C_{f}F_{2f + 1}CH₂CH₂ (f = 1 to 8) . Among these, a silicon compound having a trialkylsilyl group can be used.

In a case where R¹ in General Formula [1] includes a silicon atom, a structure of General Formula [1-1] shown below may be adopted.

R¹ₘX₃₋ₘ₋ₙ(H)ₙSi-(CH₂)ₚ-Si(H)ₙX₃₋ₘ₋ₙR¹ₘ [1-1]

In General Formula [1-1], R¹'s and X's are the same as in General Formula [1] (however, a silicon atom is not included in R¹'s), m is an integer of 1 or 2, n is an integer of 0 or 1, a sum of m and n is 1 or 2, p is an integer of 1 to 18, and a methylene chain represented by -(CH₂)ₚ- may be substituted with halogen.

In X in General Formula [1], the monovalent organic group in which the atom bonded to the Si atom is nitrogen, oxygen, or carbon includes not only a hydrogen atom, a carbon atom, a nitrogen atom, and an oxygen atom, but also a silicon atom, a sulfur atom, a halogen atom, and the like.

Examples of the above-described monovalent organic group in which the atom bonded to the Si atom is nitrogen include an isocyanate group, an amino group, a dialkylamino group, an isothiocyanate group, an azido group, an acetamide group, - NHC(=O)CF₃, -N(CH₃)C(=O)CH₃, -N(CH₃)C(=O)CF₃, -N=C(CH₃)OSi(CH₃)₃, - N=C(CF₃)OSi(CH₃)₃, -NHC(=O)-OSi(CH₃)₃, -NHC(=O)-NH-Si(CH₃)₃, an imidazole ring, a triazole ring, a tetrazole ring, an oxazolidinone ring, a morpholine ring, -NH-C(=O)-Si(CH₃)₃, - N(S(=O)₂R⁴)₂ (here, R⁴'s each independently represent a group selected from the group consisting of a monovalent hydrocarbon group having 1 to 8 carbon atoms, in which a part or all of hydrogen atoms may be replaced with fluorine atoms, and a fluorine atom), and a substituent having a structure of General Formula [1-2]. 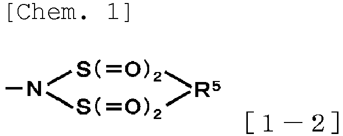 (in General Formula [1-2], R⁵'s are each independently a divalent hydrocarbon group having 1 to 8 carbon atoms, in which a part or all of hydrogen atoms may be replaced with fluorine atoms), -N=C(NR⁶₂)₂, -N=C(NR⁶₂)R⁶ (here, R⁶'s are each independently selected from a hydrogen group, a -C=N group, a - NO₂ group, and a hydrocarbon group in which a part or all of hydrogen atoms may be replaced with fluorine atoms; the hydrocarbon group may have an oxygen atom and/or a nitrogen atom), -N(R^{a1})(R^{a2}) (here, R^{a1} represents a hydrogen atom or a saturated or unsaturated alkyl group, and R^{a2} represents a saturated or unsaturated alkyl group, a saturated or unsaturated cycloalkyl group, or a saturated or unsaturated heterocycloalkyl group; R^{a1} and R^{a2} may be bonded to each other to form a saturated or unsaturated heterocycloalkyl group having a nitrogen atom), - N(R^{a3})-Si(R^{a4})(R^{a5})(R^{a6}) (here, R^{a3} represents a hydrogen atom, a hydrocarbon group having 1 to 4 carbon atoms, a trimethylsilyl group, or a dimethylsilyl group, R^{a4}, R^{a5}, and R^{a6} each independently represent a hydrogen atom or an organic group, and the total number of carbon atoms included in R^{a4}, R^{a5}, and R^{a6} is 1 or more), and -N(R^{a7})-C(=O)R^{a8} (here, R^{a7} represents a hydrogen atom, a methyl group, a trimethylsilyl group, or a dimethylsilyl group, and R^{a8} represents a hydrogen atom, a saturated or unsaturated alkyl group, a fluorine-containing alkyl group, or a trialkylsilylamino group)

Examples of the silylating agent that X in General Formula [1] is a monovalent organic group in which the atom bonded to the Si atom is nitrogen include aminosilanes such as CH₃Si(NH₂)₃, C₂H₅Si(NH₂)₃, C₃H₇Si(NH₂)₃, C₄H₉Si(NH₂)₃, C₅H₁₁Si(NH₂)₃, C₆H₁₃Si(NH₂)₃, C₇H₁₅Si(NH₂)₃, C₈H₁₇Si(NH₂)₃, C₉H₁₉Si(NH₂)₃, C₁₀H₂₁Si(NH₂)₃, C₁₁H₂₃Si(NH₂)₃, C₁₂H₂₅Si(NH₂)₃, C₁₃H₂₇Si(NH₂)₃, C₁₄H₂₉Si(NH₂)₃, C₁₅H₃₁Si(NH₂)₃, C₁₆H₃₃Si(NH₂)₃, C₁₇H₃₅Si(NH₂)₃, C₁₈H₃₇Si(NH₂)₃, (CH₃)₂Si(NH₂)₂, C₂H₅Si(CH₃)(NH₂)₂, (C₂H₅)₂Si(NH₂)₂, C₃H₇Si(CH₃)(NH₂)₂, (C₃H₇)₂Si(NH₂)₂, C₄H₉Si(CH₃)(NH₂)₂, (C₄H₉)₂Si(NH₂)₂, C₅H₁₁Si(CH₃)(NH₂)₂, C₆H₁₃Si(CH₃)(NH₂)₂, C₇H₁₅Si(CH₃)(NH₂)₂, C₈H₁₇Si(CH₃)(NH₂)₂, C₉H₁₉Si(CH₃)(NH₂)₂, C₁₀H₂₁Si(CH₃)(NH₂)₂, C₁₁H₂₃Si(CH₃)(NH₂)₂, C₁₂H₂₅Si(CH₃)(NH₂)₂, C₁₃H₂₇Si(CH₃)(NH₂)₂, C₁₄H₂₉Si(CH₃)(NH₂)₂, C₁₅H₃₁Si(CH₃)(NH₂)₂, C₁₆H₃₃Si(CH₃)(NH₂)₂, C₁₇H₃₅Si(CH₃)(NH₂)₂, C₁₈H₃₇Si(CH₃)(NH₂)₂, (CH₃)₃SiNH₂, C₂H₅Si(CH₃)₂NH₂, (C₂H₅)₂Si(CH₃)NH₂, (C₂H₅)₃SiNH₂, C₃H₇Si(CH₃)₂NH₂, (C₃H₇)₂Si(CH₃)NH₂, (C₃H₇)₃SiNH₂, C₄H₉Si(CH₃)₂NH₂, (C₄H₉)₃SiNH₂, C₅H₁₁Si(CH₃)₂NH₂, C₆H₁₃Si(CH₃)₂NH₂, C₇H₁₅Si(CH₃)₂NH₂, C₈H₁₇Si(CH₃)₂NH₂, C₉H₁₉Si(CH₃)₂NH₂, C₁₀H₂₁Si(CH₃)₂NH₂, C₁₁H₂₃Si(CH₃)₂NH₂, C₁₂H₂₅Si(CH₃)₂NH₂, C₁₃H₂₇Si(CH₃)₂NH₂, C₁₄H₂₉Si(CH₃)₂NH₂, C₁₅H₃₁Si(CH₃)₂NH₂, C₁₆H₃₃Si(CH₃)₂NH₂, C₁₇H₃₅Si(CH₃)₂NH₂, C₁₈H₃₇Si(CH₃)₂NH₂, (CH₃)₂Si(H)NH₂, CH₃Si(H)₂NH₂, (C₂H₅)₂Si(H)NH₂, C₂H₅Si(H)₂NH₂, C₂H₅Si(CH₃)(H)NH₂, (C₃H₇)₂Si(H)NH₂, C₃H₇Si(H)₂NH₂, CF₃CH₂CH₂Si(NH₂)₃, C₂F₅CH₂CH₂Si(NH₂)₃, C₃F₇CH₂CH₂Si(NH₂)₃, C₄F₉CH₂CH₂Si(NH₂)₃, C₅F₁₁CH₂CH₂Si(NH₂)₃, C₆F₁₃CH₂CH₂Si(NH₂)₃, C₇F₁₅CH₂CH₂Si(NH₂)₃, C₈F₁₇CH₂CH₂Si(NH₂)₃, CF₃CH₂CH₂Si(CH₃)(NH₂)₂, C₂F₅CH₂CH₂Si(CH₃)(NH₂)₂, C₃F₇CH₂CH₂Si(CH₃)(NH₂)₂, C₄F₉CH₂CH₂Si(CH₃)(NH₂)₂, C₅F₁₁CH₂CH₂Si(CH₃)(NH₂)₂, C₆F₁₃CH₂CH₂Si(CH₃)(NH₂)₂, C₇F₁₅CH₂CH₂Si(CH₃)(NH₂)₂, C₈F₁₇CH₂CH₂Si(CH₃)(NH₂)₂, CF₃CH₂CH₂Si(CH₃)₂NH₂, C₂F₅CH₂CH₂Si(CH₃)₂NH₂, C₃F₇CH₂CH₂Si(CH₃)₂NH₂, C₄F₉CH₂CH₂Si(CH₃)₂NH₂, C₅F₁₁CH₂CH₂Si(CH₃)₂NH₂, C₆F₁₃CH₂CH₂Si(CH₃)₂NH₂, C₇F₁₅CH₂CH₂Si(CH₃)₂NH₂, C₈F₁₇CH₂CH₂Si(CH₃)₂NH₂, CF₃CH₂CH₂Si(CH₃)(H)NH₂, aminodimethylvinylsilane, aminodimethylphenylethylsilane, aminodimethylphenylsilane, aminomethyldiphenylsilane, and aminodimethyl-t-butylsilane; and a group in which the amino group (-NH₂ group) of the aminosilane is replaced with -N=C=O, a dialkylamino group (-N(CH₃)₂, -N(C₂H₅)₂, and the like), a t-butylamino group, an allylamino group, -N=C=S, -N₃, -NHC(=O)CH₃, -NHC(=O)CF₃, -N(CH₃)C(=O)CH₃, -N(CH₃)C(=O)CF₃, -N=C(CH₃)OSi(CH₃)₃, -N=C(CF₃)OSi(CH₃)₃, -NHC(=O)-OSi(CH₃)₃, -NHC(=O)-NH-Si(CH₃)₃ (for example, N,N'-bis(trimethylsilyl)urea and the like), an imidazole ring (for example, N-trimethylsilylimidazole and the like), a triazole ring (for example, N-trimethylsilyltriazole and the like), a tetrazole ring, an oxazolidinone ring, a morpholine ring, -NH-C(=O)-Si(CH₃)₃, -N(S(=O)₂R⁴)₂ (R⁴ is as described above; for example, N-((trimethylsilyl)bis(trifluoromethanesulfonyl)imide and the like), or the substituent having the above-described structure of General Formula [1-2]. 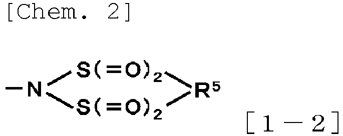 (in General Formula [1-2], R⁵ is as described above; for example, N-(trimethylsilyl) N,N-difluoromethane-1,3-bis (sulfonyl) imide and the like), -N=C(NR⁶₂)₂-, -N=C(NR⁶₂)R⁶ (R⁶ is as described above; for example, 2-trimethylsilyl-1,1,3,3-tetramethylguanidine and the like), -N(R^{a1})(R^{a2}) (R^{a1} and Ra2 are as described above), -N(R^{a3})-Si(R^{a4})(R^{a5})(R^{a6}) (R^{a3}, R^{a4}, R^{a5}, and R^{a6} are as described above; for example, hexamethyldisilazane, N-methylhexamethyldisilazane, 1,1,3,3-tetramethyldisilazane, 1,3-dimethyldisilazane, 1,3-di-N-octyltetramethyldisilazane, 1,3-divinyltetramethyldisilazane, heptamethyldisilazane, N-allyl-N,N-bis(trimethylsilyl)amine, 1,3-diphenyltetramethyldisilazane, 1,1,3,3-tetraphenyl-1,3-dimethyldisilazane, nonamethyltrisilazane, pentamethylethyldisilazane, pentamethylvinyldisilazane, pentamethylpropyldisilazane, pentamethyl-t-butyldisilazane, pentamethylphenyldisilazane, trimethyltriethyldisilazane, and the like), or -N(R^{a7})-C(=O)R^{a8} (R^{a7} and R^{a8} are as described above; for example, N-trimethylsilylacetamide, N-trimethylsilyltrifluoroacetamide, N-methyl-N-trimethylsilylacetamide, N-methyl-N-trimethylsilyltrifluoroacetamide, bis(trimethylsilyl)acetamide, bis(trimethylsilyl)trifluoroacetamide, and the like)

Examples of the silylating agent that X in General Formula [1] is a monovalent organic group in which the atom bonded to the Si atom is oxygen include a group in which the amino group (-NH₂ group) of the above-described aminosilane is replaced with -O-C(=A)R^{a9} (here, A represents O, CHR^{a10}, CHOR^{a10}, CR^{a10}R^{a10}, or NR^{a11}, where R^{a9} and R^{a10} each independently represent a hydrogen atom, a saturated or unsaturated alkyl group, a saturated or unsaturated cycloalkyl group, a fluorine-containing alkyl group, a chlorine-containing alkyl group, a trialkylsilyl group, a trialkylsiloxy group, an alkoxy group, a phenyl group, a phenylethyl group, or an acetyl group, and R^{a11} represents a hydrogen atom, an alkyl group, or a trialkylsilyl group; for example, trimethylsilyl acetate, dimethylsilylacetate, monomethylsilylacetate, trimethylsilyltrifluoroacetate, dimethylsilyltrifluoroacetate, monomethylsilyltrifluoroacetate, trimethylsilyltrichloroacetate, trimethylsilylpropionate, trimethylsilyl butyrate, and the like),-O-C(R^{a12})=N(R^{a13}) (here, R^{a12} represents a hydrogen atom, a saturated or unsaturated alkyl group, a fluorine-containing alkyl group, or a trialkylsilylamino group, and R^{a13} represents a hydrogen atom, an alkyl group, or a trialkylsilyl group),-O-C(R^{a14})=CH-C(=O)R^{a15} (here, R^{a14} and R^{a15} each independently represent a hydrogen atom or an organic group; for example, trimethylsilyloxy-3-penten-2-one, 2-trimethylsiloxypenta-2-en-4-one, and the like), -OR^{a16} (here, R^{a16} represents a saturated or unsaturated alkyl group, a saturated or unsaturated cycloalkyl group, or a fluorine-containing alkyl group; for example, alkylmethoxysilanes such as CH₃Si(OCH₃)₃, C₂H₅Si(OCH₃)₃, C₃H₇Si(OCH₃)₃, C₄H₉Si(OCH₃)₃, C₅H₁₁Si(OCH₃)₃, C₆H₁₃Si(OCH₃)₃, C₇H₁₅Si(OCH₃)₃, C₈H₁₇Si(OCH₃)₃, C₉H₁₉Si(OCH₃)₃, C₁₀H₂₁Si(OCH₃)₃, C₁₁H₂₃Si(OCH₃)₃, C₁₂H₂₅Si(OCH₃)₃, C₁₃H₂₇Si(OCH₃)₃, C₁₄H₂₉Si(OCH₃)₃, C₁₅H₃₁Si(OCH₃)₃, C₁₆H₃₃Si(OCH₃)₃, C₁₇H₃₅Si(OCH₃)₃, C₁₈H₃₇Si(OCH₃)₃, (CH₃)₂Si(OCH₃)₂, C₂H₅Si(CH₃)(OCH₃)₂, (C₂H₅)₂Si(OCH₃)₂, C₃H₇Si(CH₃)(OCH₃)₂, (C₃H₇)₂Si(OCH₃)₂, C₄H₉Si(CH₃)(OCH₃)₂, (C₄H₉)₂Si(OCH₃)₂, C₅H₁₁Si(CH₃)(OCH₃)₂, C₆H₁₃Si(CH₃)(OCH₃)₂, C₇H₁₅Si(CH₃)(OCH₃)₂, C₈H₁₇Si(CH₃)(OCH₃)₂, C₉H₁₉Si(CH₃)(OCH₃)₂, C₁₀H₂₁Si(CH₃)(OCH₃)₂, C₁₁H₂₃Si(CH₃)(OCH₃)₂, C₁₂H₂₅Si(CH₃)(OCH₃)₂, C₁₃H₂₇Si(CH₃)(OCH₃)₂, C₁₄H₂₉Si(CH₃)(OCH₃)₂, C₁₅H₃₁Si(CH₃)(OCH₃)₂, C₁₆H₃₃Si(CH₃)(OCH₃)₂, C₁₇H₃₅Si(CH₃)(OCH₃)₂, C₁₈H₃₇Si(CH₃)(OCH₃)₂, (CH₃)₃SiOCH₃, C₂H₅Si(CH₃)₂OCH₃, (C₂H₅)₂Si(CH₃)OCH₃, (C₂H₅)₃SiOCH₃, C₃H₇Si(CH₃)₂OCH₃, (C₃H₇)₂Si(CH₃)OCH₃, (C₃H₇)₃SiOCH₃, C₄H₉Si(CH₃)₂OCH₃, (C₄H₉)₃SiOCH₃, C₅H₁₁Si(CH₃)₂OCH₃, C₆H₁₃Si(CH₃)₂OCH₃, C₇H₁₅Si(CH₃)₂OCH₃, C₈H₁₇Si(CH₃)₂OCH₃, C₉H₁₉Si(CH₃)₂OCH₃, C₁₀H₂₁Si(CH₃)₂OCH₃, C₁₁H₂₃Si(CH₃)₂OCH₃, C₁₂H₂₅Si(CH₃)₂OCH₃, C₁₃H₂₇Si(CH₃)₂OCH₃, C₁₄H₂₉Si(CH₃)₂OCH₃, C₁₅H₃₁Si(CH₃)₂OCH₃, C₁₆H₃₃Si(CH₃)₂OCH₃, C₁₇H₃₅Si(CH₃)₂OCH₃, C₁₈H₃₇Si(CH₃)₂OCH₃, (CH₃)₂Si(H)OCH₃, CH₃Si(H)₂OCH₃, (C₂H₅)₂Si(H)OCH₃, C₂H₅Si(H) ₂OCH₃, C₂H₅Si(CH₃)(H) OCH₃, and (C₃H₇)₂Si(H)OCH₃, fluoroalkylmethoxysilanes such as CF₃CH₂CH₂Si(OCH₃)₃, C₂F₅CH₂CH₂Si(OCH₃)₃, C₃F₇CH₂CH₂Si(OCH₃)₃, C₄F₉CH₂CH₂Si(OCH₃)₃, C₅F₁₁CH₂CH₂Si(OCH₃)₃, C₆F₁₃CH₂CH₂Si(OCH₃)₃, C₇F₁₅CH₂CH₂Si(OCH₃)₃, C₈F₁₇CH₂CH₂Si(OCH₃)₃, CF₃CH₂CH₂Si(CH₃)(OCH₃)₂, C₂F₅CH₂CH₂Si(CH₃)(OCH₃)₂, C₃F₇CH₂CH₂Si(CH₃)(OCH₃)₂, C₄F₉CH₂CH₂Si(CH₃)(OCH₃)₂, C₅F₁₁CH₂CH₂Si(CH₃)(OCH₃)₂, C₆F₁₃CH₂CH₂Si(CH₃)(OCH₃)₂, C₇F₁₅CH₂CH₂Si(CH₃)(OCH₃)₂, C₈F₁₇CH₂CH₂Si(CH₃)(OCH₃)₂, CF₃CH₂CH₂Si(CH₃)₂OCH₃, C₂F₅CH₂CH₂Si(CH₃)₂OCH₃, C₃F₇CH₂CH₂Si(CH₃)₂OCH₃, C₄F₉CH₂CH₂Si(CH₃)₂OCH₃, C₅F₁₁CH₂CH₂Si(CH₃)₂OCH₃, C₆F₁₃CH₂CH₂Si(CH₃)₂OCH₃, C₇F₁₅CH₂CH₂Si(CH₃)₂OCH₃, C₈F₁₇CH₂CH₂Si(CH₃)₂OCH₃, and CF₃CH₂CH₂Si(CH₃)(H)OCH₃, a compound in which the methyl group portion of the methoxy group of methoxysilane is replaced with a monovalent hydrocarbon group having 2 to 18 carbon atoms, in which a part or all of hydrogen atoms may be replaced with fluorine atoms, and the like),-O-S(=O)₂-R^{a17} (here, R^{a17} represents an alkyl group having 1 to 6 carbon atoms, a perfluoroalkyl group, a phenyl group, a tolyl group, or a -O-Si(CH₃)₃ group; for example, trimethylsilylsulfonate, trimethylsilylbenzenesulfonate, trimethylsilyltoluenesulfonate, trimethylsilyltrifluoromethanesulfonate, trimethylsilylperfluorobutanesulfonate, bistrimethylsilylsulfate, and the like), or -O-P(-O-Si(CH₃)₃)₂ (for example, tristrimethylsilylphosphite and the like).

In addition, examples of the silylating agent that X in General Formula [1] is a monovalent organic group in which the atom bonded to the Si atom is oxygen also include siloxane compounds such as hexamethyldisiloxane, 1,3-diphenyl-1,3-dimethyldisiloxane, 1,1,3,3-tetramethyldisiloxane, 1,1,1-triethyl-3,3-dimethyldisiloxane, 1,1,3,3-tetra-n-octyldimethyldisiloxane, bis(nonafluorohexyl)tetramethyldisiloxane, 1,3-bis(trifluoropropyl)tetramethyldisiloxane, 1,3-di-n-butyltetramethyldisiloxane, 1,3-di-n-octyltetramethyldisiloxane, 1,3-diethyltetramethyldisiloxane, 1,3-diphenyltetramethyldisiloxane, hexa-n-butyldisiloxane, hexaethyldisiloxane, hexavinyldisiloxane, 1,1,3,3-tetraisopropyldisiloxane, vinylpentamethyldisiloxane, 1,3-bis(3-chloroisobutyl)tetramethyldisiloxane, hexaphenyldisiloxane, 1,1,1-triethyl-3,3,3-trimethyldisiloxane, 1,3-bis(chloromethyl)tetramethyldisiloxane, 1,1,3,3-tetraphenyldimethyldisiloxane, pentamethyldisiloxane, 1,3-bis (3-chloropropyl) tetramethyldisiloxane, 1,3-dichloro-1,3-diphenyl-1,3-dimethyldisiloxane, n-butyl-1,1,3,3-tetramethyldisiloxane, 1,3-di-t-butyldisiloxane, vinyl-1,1,3,3,-tetramethyldisiloxane, 1,1,1-trimethyl-3,3,3-triphenyldisiloxane, 3,3-diphenyltetramethyltrisiloxane, 3-phenylheptamethyltrisiloxane, hexamethylcyclotrisiloxane, n-propylheptamethyltrisiloxane, 3-ethylheptamethyltrisiloxane, 3-(3,3,3-trifluoropropyl)heptamethyltrisiloxane, 1,1,3,5,5-pentaphenyl-1,3,5-trimethyltrisiloxane, octamethyltrisiloxane, 1,1,5,5-tetraphenyl-1,3,3,5-tetramethyltrisiloxane, hexaphenylcyclotrisiloxane, 1,1,1,5,5,5-hexamethyltrisiloxane, 3-phenyl-1,1,3,5,5-pentamethyltrisiloxane, 1,3,5-trivinyl-1,1,3,5,5-pentamethyltrisiloxane, 1,3,5-trivinyl-1,3,5-trimethylcyclotrisiloxane, 3-octylheptamethyltrisiloxane, 1,3,5-triphenyltrimethylcyclotrisiloxane, 1,1,1,3,3,5,5-heptamethyltrisiloxane, 1,1,3,3,5,5-hexamethyltrisiloxane, 1,1,1,5,5,5-hexaethyl-3-methyltrisiloxane, furfuryloxytrisiloxane, tetrakis(dimethylsiloxy)silane, 1,1,3,3,5,5,7,7-octamethyltetrasiloxane, diphenylsiloxane-dimethylsiloxane copolymer, octamethylcyclotetrasiloxane, 1,3-bis(trimethylsiloxy)-1,3-dimethyldisiloxane, tetra-n-propyltetramethylcyclotetrasiloxane, octaethylcyclotetrasiloxane, decamethyltetrasiloxane, dodecamethylcyclohexasiloxane, dodecamethylpentasiloxane, tetradecamethylhexasiloxane, hexaphenylcyclotrisiloxane, polydimethylsiloxane, polyoctadecylmethylsiloxane, decamethylcyclopentasiloxane, poly(3,3,3-trifluoropropylmethylsiloxane), polydimethylsiloxane terminalized with trimethylsiloxy, and 1,1,3,3,5,5,7,7,9,9-decamethylpentasiloxane.

Examples of a silylating agent that X in General Formula [1] is a monovalent organic group in which the atom bonded to the Si atom is carbon include a group in which the amino group (-NH₂ group) in the above-described aminosilane is replaced with -C(S(=O)₂R⁷)₃ (here, R⁷'s each independently represent a group selected from the group consisting of a monovalent hydrocarbon group having 1 to 8 carbon atoms, in which a part or all of hydrogen atoms may be replaced with fluorine atoms, and a fluorine atom; for example, (trimethylsilyl)tris(trifluoromethanesulfonyl)methide and the like) .

In addition, examples of a silylating agent that X in General Formula [1] is a monovalent organic group in which the atom bonded to the Si atom is halogen include a group in which the amino group (-NH₂ group) in the above-described aminosilane is replaced with a chloro group, a bromo group, or an iodo group (for example, chlorotrimethylsilane, bromotrimethylsilane, and the like).

In General Formula [1], b is preferably 0. In addition, X is more preferably a monovalent organic group in which the atom bonded to the Si atom is nitrogen or oxygen. In addition, R¹ is preferably a methyl group.

As the above-described silylating agent, a silazane compound can be included.

Examples of the above-described silazane compound include acyclic disilazane compounds such as hexamethyldisilazane, heptamethyldisilazane, tetramethyldisilazane, diethyltetramethyldisilazane, dipropyltetramethyldisilazane, dibutyltetramethyldisilazane, dihexyltetramethyldisilazane, dioctyltetramethyldisilazane, and didecyltetramethyldisilazane; cyclic disilazane compounds such as 2,2,5,5-tetramethyl-2,5-disila-1-azacyclopentane and 2,2,6,6-tetramethyl-2,6-disila-1-azacyclohexane; cyclic trisilazane compounds such as 2,2,4,4,6,6-hexamethylcyclotrisilazane and 2,4,6-trimethyl-2,4,6-trivinylcyclotrisilazane; and cyclic tetracyclazane compounds such as 2,2,4,4,6,6,8,8-octamethylcyclotetrasilazane.

More suitable specific examples of the silylating agent include one or two or more selected from the group consisting of hexamethyldisilazane, heptamethyldisilazane, N-(trimethylsilyl)dimethylamine, bis(dimethylamino)dimethylsilane, bis(trimethylsilyl)trifluoroacetamide, N-methyl-N-trimethylsilyltrifluoroacetamide, N-trimethylsilylacetamide, N-trimethylsilylimidazole, trimethylsilyl triazole, bistrimethylsilyl sulfate, 2,2,5,5-tetramethyl-2,5-disila-1-azacyclopentane, 2,2,4,4,6,6-hexamethylcyclotrisilazane, hexamethyldisiloxane, trimethylsilyl trifluoroacetate, trimethylsilyl trifluoromethanesulfonate, trimethylsilyl benzene sulfonate, and trimethylsilyl toluene sulfonate.

### (Catalytic compound)

The above-described composition for film formation contains, in addition to the above-described silylating agent, a catalytic compound which promotes the silylation reaction by the silylating agent, and an aprotic solvent to be described later. As the catalytic compound, it is preferable to use one or more kinds selected from the group consisting of a compound A, an acid imidized product, a compound having a guanidine skeleton, a nitrogen-containing heterocyclic compound not containing a silicon atom, and a silylated heterocyclic compound, which will be described later.

Here, the catalytic compound is a compound which can promote the above-described reaction between the main surface and the silylating agent or can enhance liquid-repellent performance of the water-repellent film to be formed, and the catalytic compound itself or a modified product thereof may form a part of the water-repellent film.

The above-described compound A may be at least one kind selected from the group consisting of a carboxylic acid represented by General Formula [16], an anhydride of the carboxylic acid, a salt of the carboxylic acid, and a carboxylic acid derivative represented by General Formula [17].

R²⁹-C(=O)OH [16]

[in General Formula [16], R²⁹ is a group selected from the group consisting of monovalent hydrocarbon groups having 1 to 8 carbon atoms, in which a part or all of hydrogen atoms may be replaced with fluorine atoms]

R^{29'}-C(=O)O-Si(H)₃₋ₕ(R³⁰)ₕ [17]

[in General Formula [17], R^{29'} represents a monovalent hydrocarbon group having 1 to 8 carbon atoms, in which a part or all of hydrogen atoms may be replaced with fluorine atoms, R^{30'}s each independently represent at least one group selected from monovalent hydrocarbon groups having 1 to 18 carbon atoms, in which a part or all of hydrogen atoms may be replaced with fluorine atoms, and h is an integer of 1 to 3]

In addition, the above-described compound A may be at least one kind selected from the group consisting of a sulfonic acid represented by General Formula [3], an anhydride of the sulfonic acid, a salt of the sulfonic acid, and a sulfonic acid derivative represented by General Formula [4].

R⁸-S(=O)₂OH [3]

[in General Formula [3], R⁸ is a group selected from the group consisting of a monovalent hydrocarbon groups having 1 to 8 carbon atoms, in which a part or all of hydrogen atoms may be replaced with fluorine atoms, and a hydroxyl group]

R⁸'-S(=O)₂O-Si(H)₃₋ᵣ(R⁹)ᵣ [4]

[in General Formula [4], R⁸' represents a monovalent hydrocarbon group having 1 to 8 carbon atoms, in which a part or all of hydrogen atoms may be replaced with fluorine atoms, R⁹'s each independently represent at least one group selected from monovalent hydrocarbon groups having 1 to 18 carbon atoms, in which a part or all of hydrogen atoms may be replaced with fluorine atoms, and r is an integer of 1 to 3]

In addition, the above-described compound A may be at least one kind selected from the group consisting of a sulfonate represented by General Formula [5], a sulfonimide represented by each of General Formulae [6] and [7], sulfonimide derivatives represented by General Formulae [8] and [9], a sulfonmethide represented by General Formula [10], and a sulfonmethide derivative represented by General Formula [11].

R¹⁰-S(=O)₂OR¹¹ [5]

[in General Formula [5], R¹⁰ is a group selected from the group consisting of a monovalent hydrocarbon group having 1 to 8 carbon atoms, in which a part or all of hydrogen atoms may be replaced with fluorine atoms, and a fluorine atom, and R¹¹ is a monovalent alkyl group having 1 to 18 carbon atoms]

(R¹²-S(=O)₂)₂NH [6]

[in General Formula [6], R¹²'s are each independently a group selected from the group consisting of a monovalent hydrocarbon group having 1 to 8 carbon atoms, in which a part or all of hydrogen atoms may be replaced with fluorine atoms, and a fluorine atom] 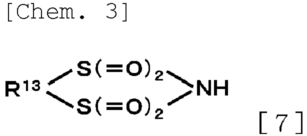 [in General Formula [7], R¹³ is a divalent hydrocarbon group having 1 to 8 carbon atoms, in which a part or all of hydrogen atoms may be replaced with fluorine atoms]

((R¹⁴-S(=O)₂)₂N)ₛSi(H)t(R¹⁵)₄₋ₛ₋ₜ [8]

[in General Formula [8], R¹⁴'s are each independently a group selected from the group consisting of a monovalent hydrocarbon group having 1 to 8 carbon atoms, in which a part or all of hydrogen atoms may be replaced with fluorine atoms, and a fluorine atom, R¹⁵'s are each independently a monovalent hydrocarbon group having 1 to 18 carbon atoms, in which a part or all of hydrogen atoms may be replaced with fluorine atoms, s is an integer of 1 to 3, t is an integer of 0 to 2, and a sum of s and t is 3 or less] 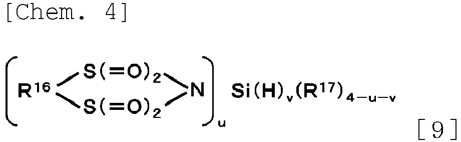 [in General Formula [9], R¹⁶'s are each independently a divalent hydrocarbon group having 1 to 8 carbon atoms, in which a part or all of hydrogen atoms may be replaced with fluorine atoms, R¹⁷'s are each independently a monovalent hydrocarbon group having 1 to 18 carbon atoms, in which a part or all of hydrogen atoms may be replaced with fluorine atoms, u is an integer of 1 to 3, v is an integer of 0 to 2, and a sum of u and v is 3 or less]

(R¹⁸-S(=O)₂)₃CH [10]

[in General Formula [10], R¹⁸'s are each independently a group selected from the group consisting of a monovalent hydrocarbon group having 1 to 8 carbon atoms, in which a part or all of hydrogen atoms may be replaced with fluorine atoms, and a fluorine atom]

((R¹⁹-S(=O)₂)₃C)_{w}Si(H)ₓ(R²⁰)_{4-w-x} [11]

[in General Formula [11], R¹⁹'s are each independently a group selected from the group consisting of a monovalent hydrocarbon group having 1 to 8 carbon atoms, in which a part or all of hydrogen atoms may be replaced with fluorine atoms, and a fluorine atom, R²⁰'s are each independently a monovalent hydrocarbon group having 1 to 18 carbon atoms, in which a part or all of hydrogen atoms may be replaced with fluorine atoms, w is an integer of 1 to 3, x is an integer of 0 to 2, and a sum of w and x is 3 or less]

Specific examples of the above-described compound A include trimethylsilyl trifluoroacetate, trimethylsilyl trifluoromethanesulfonate, dimethylsilyl trifluoroacetate, dimethylsilyl trifluoromethanesulfonate, butyldimethylsilyl trifluoroacetate, butyldimethylsilyl trifluoromethanesulfonate, hexyldimethylsilyl trifluoroacetate, hexyldimethylsilyl trifluoromethanesulfonate, octyldimethylsilyl trifluoroacetate, octyldimethylsilyl trifluoromethanesulfonate, decyldimethylsilyl trifluoroacetate, and decyldimethylsilyl trifluoromethanesulfonate, and one or more kinds selected from these compounds can be included. These may be used alone or in combination of two or more kinds thereof.

As a more preferred specific example of the compound A, for example, one or two or more selected from the group consisting of trimethylsilyl trifluoroacetate, dimethylsilyl trifluoroacetate, butyldimethylsilyl trifluoroacetate, hexyldimethylsilyl trifluoroacetate, octyldimethylsilyl trifluoroacetate, and decyldimethylsilyl trifluoroacetate may be included.

As a more preferred specific example of the compound A, one or two or more selected from the group consisting of trimethylsilyl trifluoromethanesulfonate, dimethylsilyl trifluoromethanesulfonate, butyldimethylsilyl trifluoromethanesulfonate, hexyldimethylsilyl trifluoromethanesulfonate, octyldimethylsilyl trifluoromethanesulfonate, and decyldimethylsilyl trifluoromethanesulfonate may be included.

By using the above-described compound A, it is possible to realize a composition for film formation having excellent in-plane uniformity of the water contact angle and being more excellent in suppressing the decrease in water contact angle in a case of coming into contact with or being mixed with the protic liquid.

The above-described compound A may correspond to the above-described silylating agent, but in a case of being used as the catalytic compound, it means that the compound A is used in combination with other silylating agents other than the compound A. In a case of being used in combination, since the compound A is more likely to act as the catalytic compound, it is preferable that the concentration of the compound A is equal to or less than the concentration of the other silylating agents.

The above-described compound A may be a compound obtained by reacting a silicon compound represented by General Formula [2] with one or more acetic acids or sulfonic acids selected from the group consisting of trifluoroacetic acid, trifluoroacetic acid anhydride, trifluoromethanesulfonic acid, and trifluoromethanesulfonic acid anhydride.

A surplus silicon compound represented by General Formula [2], which remains without being consumed in this reaction, can be used as the above-described silylating agent together with the compound A obtained in the reaction. The silicon compound represented by General Formula [2] may be reacted with the above-described acetic acid or sulfonic acid, for example, at a molar ratio of 0.2 to 100,000 times, preferably 0.5 to 50,000 times and more preferably 1 to 10,000 times.

R²_{c}(H)_{d}Si-X_{4-c-d} [2]

[in General Formula [2], R^{2'}s have the same definition as that for R¹ above, X's have the same definition as that in General Formula [1], c is an integer of 1 to 3, d is an integer of 0 to 2, and a sum of c and d is 1 to 3]

The sum of c and d is preferably 3, it is more preferable that d is 0. In addition, in General Formula [2], examples of R²_{c}(H)_{d}Si- include (CH₃)₃Si-, (CH₃)₂(H)Si-, (C₄H₉)(CH₃)₂Si-, (C₆H₁₃)(CH₃)₂Si-, (C₈H₁₇)(CH₃)₂Si-, and (C₁₀H₂₁)(CH₃)₂Si-.

In addition, examples of the above-described acid imidized product include compounds having a chemical structure in which an acid such as a carboxylic acid and a phosphoric acid is imidized.

The above-described catalytic compound may include one or two or more selected from the group consisting of a compound having a guanidine skeleton, a nitrogen-containing heterocyclic compound not containing a silicon atom, and a silylated heterocyclic compound.

Examples of the above-described compound having a guanidine skeleton include at least one kind of compounds represented by General Formulae [12] and [13].

R²¹-N=C(NR²²₂)₂ [12]

R²¹-N=C(NR²²₂)R²² [13]

[in General Formulae [12] and [13], R²¹ is selected from a hydrogen group, a -C≡N group, a -NO₂ group, an alkylsilyl group, and a hydrocarbon group in which a part or all of hydrogen atoms may be replaced with fluorine atoms, where the hydrocarbon group may have an oxygen atom and/or a nitrogen atom, but in a case of including a nitrogen atom, the hydrocarbon group has an acyclic structure; R^{22'}s are each independently selected from a hydrogen group, a -C≡N group, a -NO₂ group, and a hydrocarbon group in which a part or all of hydrogen atoms may be replaced with fluorine atoms, where the hydrocarbon group may have an oxygen atom and/or a nitrogen atom, but in a case of including a nitrogen atom, the hydrocarbon group has an acyclic structure]

In addition, examples of the above-described compound having a guanidine skeleton include guanidine, 1,1,3,3-tetramethylguanidine, 2-tert-butyl-1,1,3,3-tetramethylguanidine, 1,3-diphenylguanidine, 1,2,3-triphenylguanidine, N,N'-diphenylformamidine, and 2,2,3,3,3-pentafluoropropylamidine.

In addition, examples of the nitrogen-containing heterocyclic compound not containing a silicon atom and the silylated heterocyclic compound include at least one kind of compounds represented by General Formulae [14] and [15]. 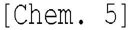 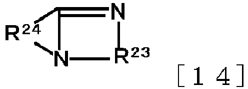 [in General Formula [14], R²³ and R²⁴ each independently represent a divalent organic group composed of a carbon atom and/or a nitrogen atom, and a hydrogen atom, the total number of carbon atoms and nitrogen atoms is 1 to 9, and in a case of 2 or more, a carbon atom which does not form a ring may be present] 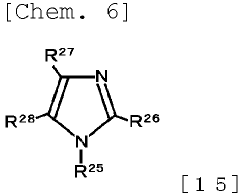 [in General Formula [15], R²⁵ represents an alkyl group having 1 to 6 carbon atoms, in which a part or all of hydrogen atoms may be replaced with fluorine atoms, a cycloalkyl group having 3 to 8 carbon atoms, in which a part or all of hydrogen atoms may be replaced with fluorine atoms, a trialkylsilyl group having an alkyl group having 1 to 8 carbon atoms, in which a part or all of hydrogen atoms may be replaced with fluorine atoms, an alkenyl group having 2 to 6 carbon atoms, in which a part or all of hydrogen atoms may be replaced with fluorine atoms, an alkoxy group having 1 to 6 carbon atoms, in which a part or all of hydrogen atoms may be replaced with fluorine atoms, a cycloalkyloxy group having 3 to 8 carbon atoms, in which a part or all of hydrogen atoms may be replaced with fluorine atoms, an aliphatic acyl group having 2 to 7 carbon atoms, in which a part or all of hydrogen atoms may be replaced with fluorine atoms, an aryl group having 6 to 20 carbon atoms, in which a part or all of hydrogen atoms may be replaced with fluorine atoms, an aralkyl group having 7 to 20 carbon atoms, in which a part or all of hydrogen atoms may be replaced with fluorine atoms, an arylcarbonyl group having 7 to 20 carbon atoms, in which a part or all of hydrogen atoms may be replaced with fluorine atoms, a carboxyalkyl group having 2 to 7 carbon atoms, in which a part or all of hydrogen atoms may be replaced with fluorine atoms, an amino group, a monoalkylamino group having an alkyl group having 1 to 6 carbon atoms, in which a part or all of hydrogen atoms may be replaced with fluorine atoms, a dialkylamino group having an alkyl group having 1 to 6 carbon atoms, in which a part or all of hydrogen atoms may be replaced with fluorine atoms, an aminoalkyl group having 1 to 6 carbon atoms, in which a part or all of hydrogen atoms may be replaced with fluorine atoms, a nitro group, a cyano group, a hydrogen group, a hydroxyl group, a mercapto group, an alkylthio group having 1 to 6 carbon atoms, in which a part or all of hydrogen atoms may be replaced with fluorine atoms, or a halogen group; and R²⁶, R²⁷, and R²⁸ each independently represent an alkyl group having 1 to 6 carbon atoms, in which a part or all of hydrogen atoms may be replaced with fluorine atoms, or a hydrogen group]

R²⁵ is preferably an alkyl group having 1 to 6 carbon atoms, in which a part or all of hydrogen atoms may be replaced with fluorine atoms, a cycloalkyl group having 3 to 8 carbon atoms, in which a part or all of hydrogen atoms may be replaced with fluorine atoms, a trialkylsilyl group having an alkyl group having 1 to 8 carbon atoms, in which a part or all of hydrogen atoms may be replaced with fluorine atoms, an alkenyl group having 2 to 6 carbon atoms, in which a part or all of hydrogen atoms may be replaced with fluorine atoms, a cycloalkyloxy group having 3 to 8 carbon atoms, in which a part or all of hydrogen atoms may be replaced with fluorine atoms, an aliphatic acyl group having 2 to 7 carbon atoms, in which a part or all of hydrogen atoms may be replaced with fluorine atoms, a phenyl group, a benzyl group, an arylcarbonyl group having 7 to 20 carbon atoms, in which a part or all of hydrogen atoms may be replaced with fluorine atoms, an amino group, a monoalkylamino group having an alkyl group having 1 to 6 carbon atoms, in which a part or all of hydrogen atoms may be replaced with fluorine atoms, a dialkylamino group having an alkyl group having 1 to 6 carbon atoms, in which a part or all of hydrogen atoms may be replaced with fluorine atoms, an aminoalkyl group having 1 to 6 carbon atoms, in which a part or all of hydrogen atoms may be replaced with fluorine atoms, a hydrogen group, an alkylthio group having 1 to 6 carbon atoms, in which a part or all of hydrogen atoms may be replaced with fluorine atoms, or a halogen group.

The number of carbon atoms in the above-described alkyl group having 1 to 6 carbon atoms as R²⁵ is preferably 1 to 4 and more preferably 1 or 2. Specific examples of the alkyl group include a methyl group, an ethyl group, an n-propyl group, an isopropyl group, an n-butyl group, an isobutyl group, a sec-butyl group, a tert-butyl group, an n-pentyl group, and an n-hexyl group. Among these, a methyl group or an ethyl group is preferable, and a methyl group is more preferable. In addition, a halogen atom such as a chlorine atom, a bromine atom, and an iodine atom may be included.

The number of carbon atoms in the above-described cycloalkyl group having 3 to 8 carbon atoms as R²⁵ is preferably 3 to 7 and more preferably 4 to 6. Specific examples of the cycloalkyl group include a cyclopropyl group, a cyclobutyl group, a cyclopentyl group, a cyclohexyl group, a cycloheptyl group, and a cyclooctyl group.

The number of carbon atoms in the above-described trialkylsilyl group having an alkyl group having 1 to 8 carbon atoms as R²⁵ is preferably 2 to 8 and more preferably 3 to 6. Specific examples of the trialkylsilyl group include a trimethylsilyl group, a propyldimethylsilyl group, and a butyldimethylsilyl group.

The number of carbon atoms in the above-described alkenyl group having 2 to 6 carbon atoms as R²⁵ is preferably 2 to 4 and more preferably 2 or 3. Specific examples of the alkenyl group include a vinyl group, a 1-propenyl group, and a 2-propenyl group.

The number of carbon atoms in the above-described alkoxy group having 1 to 6 carbon atoms as R²⁵ is preferably 1 to 4 and more preferably 1 or 2. Specific examples of the alkoxy group include a methoxy group, an ethoxy group, an n-propyloxy group, an isopropyloxy group, an n-butyloxy group, an isobutyloxy group, a sec-butyloxy group, a tert-butyloxy group, an n-pentyloxy group, and an n-hexyloxy group. Among these, a methoxy group or an ethoxy group is preferable, and a methoxy group is more preferable.

The number of carbon atoms in the above-described cycloalkyloxy group having 3 to 8 carbon atoms as R²⁵ is preferably 3 to 7 and more preferably 4 to 6. Specific examples of the cycloalkyloxy group include a cyclopropyloxy group, a cyclobutyloxy group, a cyclopentyloxy group, a cyclohexyloxy group, a cycloheptyloxy group, and a cyclooctyloxy group.

The number of carbon atoms in the above-described aliphatic acyl group having 2 to 7 carbon atoms as R²⁵ is preferably 2 to 5 and more preferably 2 or 3. Specific examples of the aliphatic acyl group include an acetyl group, a propionyl group, a butanoyl group, a pentanoyl group, a hexanoyl group, and a heptanoyl group. Among these, an acetyl group or a propanoyl group is preferable, and an acetyl group is more preferable. In addition, a halogen atom such as a chlorine atom, a bromine atom, and an iodine atom may be included.

The number of carbon atoms in the above-described aryl group having 6 to 20 carbon atoms as R²⁵ is preferably 6 to 12. Specific examples of the aryl group include a phenyl group, an α-naphthyl group, a β-naphthyl group, a biphenyl-4-yl group, a biphenyl-3-yl group, a biphenyl-2-yl group, an anthracene-1-yl group, an anthracene-2-yl group, an anthracene-9-yl group, a phenanthrene-1-yl group, a phenanthrene-2-yl group, a phenanthrene-3-yl group, a phenanthrene-4-yl group, and a phenanthrene-9-yl group. Among these, a phenyl group, an α-naphthyl group, a β-naphthyl group, a biphenyl-4-yl group, a biphenyl-3-yl group, or a biphenyl-2-yl group is preferable, and a phenyl group is more preferable.

The number of carbon atoms in the above-described aralkyl group having 7 to 20 carbon atoms as R²⁵ is preferably 7 to 12. Specific examples of the aralkyl group include a benzyl group, a phenethyl group, a 3-phenyl-n-propyl group, a 4-phenyl-n-butyl group, an α-naphthylmethyl group, a β-naphthylmethyl group, a 2-(α-naphthyl)ethyl group, and a 2-(β-naphthyl)ethyl group. Among these groups, a benzyl group or a phenethyl group is preferable, and a benzyl group is more preferable.

The number of carbon atoms in the above-described arylcarbonyl group having 7 to 20 carbon atoms as R²⁵ is preferably 7 to 13. Specific examples of the arylcarbonyl group include a benzoyl group, an α-naphthoyl group, and a β-naphthoyl group.

The number of carbon atoms in the above-described carboxyalkyl group having 2 to 7 carbon atoms as R²⁵ is preferably 2 to 5 and more preferably 2 or 3. Specific examples of the carboxyalkyl group include a carboxymethyl group, a 2-carboxyethyl group, a 3-carboxy-n-propyl group, a 4-carboxy-n-butyl group, a 5-carboxy-n-pentyl group, and a 6-carboxy-n-hexyl group. Among these, a carboxymethyl group is preferable.

Specific examples of the alkyl group included in the monoalkylamino group having an alkyl group having 1 to 6 carbon atoms and the dialkylamino group having an alkyl group having 1 to 6 carbon atoms, described as R²⁵, include the same alkyl groups as the specific examples of the alkyl groups described above. As the specific example of the monoalkylamino group, an ethylamino group or a methylamino group is preferable, and a methylamino group is more preferable. In addition, as the specific example of the dialkylamino group, a diethylamino group or a dimethylamino group is preferable, and a dimethylamino group is more preferable.

The number of carbon atoms in the above-described aminoalkyl group having 1 to 6 carbon atoms as R²⁵ is preferably 2 to 4. Specific examples of the aminoalkyl group include a 2-aminoethyl group and a 3-aminopropyl group.

The number of carbon atoms in the above-described alkylthio group having 1 to 6 carbon atoms as R²⁵ is preferably 1 to 4 and more preferably 1 or 2. Specific examples of the alkylthio group include a methylthio group, an ethylthio group, an n-propylthio group, an isopropylthio group, an n-butylthio group, an isobutylthio group, a sec-butylthio group, a tert-butylthio group, an n-pentylthio group, and an n-hexylthio group. Among these, a methylthio group or an ethylthio group is preferable, and a methylthio group is more preferable.

In addition, the above-described nitrogen-containing heterocyclic compound not containing a silicon atom may include, in the ring, a heteroatom other than the nitrogen atom, such as an oxygen atom and a sulfur atom, may have aromaticity, or may be a compound in which two or more rings are single-bonded or are bonded to each other through a polyvalent linking group of di- or higher valent. In addition, the above-described nitrogen-containing heterocyclic compound not containing a silicon atom may have a substituent.

As the polyvalent linking group, a divalent linking group is preferable from the viewpoint that steric hindrance between the rings is small. Specific examples of the divalent linking group include an alkylene group having 1 to 6 carbon atoms, - CO-, -CS-, -O-, -S-, -NH-, -N=N-, -CO-O-, -CO-NH-, -CO-S-, -CS-O-, -CS-S-, -CO-NH-CO-, -NH-CO-NH-, -SO-, and -SO₂-.

From the viewpoint of easily preparing a uniform composition for film formation, the number of the rings included in the compound in which two or more rings are bonded to each other through the polyvalent linking group is preferably 4 or less, more preferably 3 or less, and most preferably 2. For example, in a case of a condensed ring such as a naphthalene ring, the number of rings is 2.

Examples of the nitrogen-containing heterocyclic compound not containing a silicon atom include pyridine, pyridazine, pyrazine, pyrimidine, triazine, tetrazine, pyrrole, pyrazole, imidazole, triazole, tetrazole, oxazole, isoxazole, thiazole, isothiazole, oxadiazole, thiaziazole, quinoline, isoquinoline, cinnoline, phthalazine, quinoxaline, quinazoline, indole, indazole, benzoimidazole, benzotriazole, benzoxazole, benzoisoxazole, benzothiazole, benzoisothiazole, benzoxadiazole, benzothiadiazole, saccharin, pyrrolidine, and piperidine.

Among these, pyrrole, pyrazole, imidazole, triazole, tetrazole, oxazole, isoxazole, thiazole, isothiazole, oxadiazole, thiaziazole, indole, indazole, benzoimidazole, benzotriazole, benzoxazole, benzoisoxazole, benzothiazole, benzoisothiazole, benzoxadiazole, benzothiadiazole, or saccharin is preferable; and imidazole, triazole, tetrazole, benzotriazole, or pyrazole is more preferable.

In addition, examples of the above-described silylated heterocyclic compound include a silylated imidazole compound and a silylated triazole compound. Examples of the silylated heterocyclic compound include monomethylsilyl imidazole, dimethylsilyl imidazole, trimethylsilyl imidazole, monomethylsilyl triazole, dimethylsilyl triazole, and trimethylsilyl triazole.

The above-described silylated heterocyclic compound may correspond to the above-described silylating agent, but in a case of being used as the catalytic compound, it means that the silylated heterocyclic compound is used in combination with other silylating agents other than the silylated heterocyclic compound.

### (Aprotic solvent)

The composition for film formation contains an aprotic solvent.

The above-described aprotic solvent refers to a solvent which does not contain a group in which a hydrogen atom is bonded to an oxygen atom or a nitrogen atom, such as a hydroxyl group or an amino group. The aprotic solvent is not particularly limited as long as it dissolves the above-described silylating agent and catalytic compound. As the aprotic solvent, for example, organic solvents such as hydrocarbons, esters, ethers, ketones, halogen atom-containing solvents, sulfoxide-based solvents, carbonate-based solvents, derivatives of polyhydric alcohol not having an OH group, nitrogen atom-containing solvents not having an N-H group, and silicone solvents are used. Among these, hydrocarbons, esters, ethers, halogen atom-containing solvents, sulfoxide-based solvents, or derivatives of polyhydric alcohol not having an OH group are preferable.

As the aprotic solvent, these may be used alone or in combination of two or more kinds thereof.

Examples of the above-described hydrocarbons include linear, branched, or cyclic hydrocarbon-based solvents, aromatic hydrocarbon-based solvents, and terpene-based solvents, and specific examples thereof include n-hexane, n-heptane, n-octane, n-nonane, n-decane, n-undecane, n-dodecane, n-tetradecane, n-hexadecane, n-octadecane, n-icosane, branched hydrocarbon corresponding to the carbon numbers thereof (for example, isododecane, isocetane, and the like), cyclohexane, methylcyclohexane, decalin, benzene, toluene, xylene, (ortho-, meta-, or para-)diethylbenzene, 1,3,5-trimethylbenzene, butylbenzene, naphthalene, p-menthane, o-menthane, m-menthane, diphenylmenthane, limonene, α-terpinene, β-terpinene, γ-terpinene, bornane, norbornane, pinane, α-pinene, β-pinene, carane, longifolene, and abietane.

Examples of the above-described esters include ethyl acetate, n-propyl acetate, i-propyl acetate, n-butyl acetate, i-butyl acetate, n-pentyl acetate, i-pentyl acetate, n-hexyl acetate, n-heptyl acetate, n-octyl acetate, n-pentyl formate, n-butyl propionate, ethyl butyrate, n-propyl butyrate, i-propyl butyrate, n-butyl butyrate, methyl n-octanate, methyl decanoate, methyl pyruvate, ethyl pyruvate, n-propyl pyruvate, methyl acetoacetate, ethyl acetoacetate, ethyl 2-oxobutanoate, dimethyl adipate, methyl 3-methoxypropionate, ethyl 3-methoxypropionate, methyl 3-ethoxypropionate, ethyl 3-ethoxypropionate, and ethyl ethoxyacetate.

In addition, as the above-described esters, cyclic esters such as a lactone compound may be used. Examples of the lactone compound include β-propiolactone, γ-butyrolactone, γ-valerolactone, γ-hexanolactone, γ-heptanolactone, γ-octanolactone, γ-nonanolactone, γ-decanolactone, γ-undecanolactone, γ-dodecanolactone, δ-valerolactone, δ-hexanolactone, δ-octanolactone, δ-nonanolactone, δ-decanolactone, δ-undecanolactone, δ-dodecanolactone, and ε-hexanolactone.

Examples of the above-described ethers include di-n-propyl ether, ethyl-n-butyl ether, di-n-butyl ether, ethyl-n-amyl ether, di-n-amyl ether, ethyl-n-hexyl ether, di-n-hexyl ether, di-n-octyl ether, diisopropyl ethers corresponding to the carbon numbers thereof, ethers with branched hydrocarbon groups, such as diisoamyl ether, dimethyl ether, diethyl ether, methyl ethyl ether, methyl cyclopentyl ether, diphenyl ether, tetrahydrofuran, and dioxane.

Examples of the above-described ketones include acetone, acetylacetone, methyl ethyl ketone, methyl propyl ketone, methyl butyl ketone, 2-heptanone, 3-heptanone, cyclohexanone, and isophorone.

Examples of the above-described halogen atom-containing solvent include perfluorocarbons such as perfluorooctane, perfluorononane, perfluorocyclopentane, perfluorocyclohexane, and hexafluorobenzene; hydrofluorocarbons such as 1,1,1,3,3-pentafluorobutane, octafluorocyclopentane, 2,3-dihydrodecafluoropentane, and ZEORORA H (manufactured by ZEON CORPORATION); hydrofluoroethers such as methyl perfluoropropyl ether, methyl perfluoroisobutyl ether, methyl perfluorobutyl ether, ethyl perfluorobutyl ether, ethyl perfluoroisobutyl ether, methyl perfluorohexyl ether, ethyl perfluorohexyl ether, Asahiklin AE-3000 (manufactured by Asahi Glass Co., Ltd.), Novec HFE-7100, Novec HFE-7200, Novec 7300, and Novec 7600 (all manufactured by 3M); chlorocarbons such as tetrachloromethane; hydrochlorocarbons such as chloroform; chlorofluorocarbons such as dichlorodifluoromethane; hydrochlorofluorocarbons such as 1,1-dichloro-2,2,3,3,3-pentafluoropropane, 1,3-dichloro-1,1,2,2,3-pentafluoropropane, 1-chloro-3,3,3-trifluoropropene, and 1,2-dichloro-3,3,3-trifluoropropene; perfluoroether, and perfluoropolyether.

Examples of the above-described sulfoxide-based solvent include dimethyl sulfoxide.

Examples of the above-described carbonate-based solvent include dimethyl carbonate, ethylmethyl carbonate, diethyl carbonate, and propylene carbonate.

Examples of the above-described derivative of polyhydric alcohol not having an OH group include ethylene glycol dimethyl ether, ethylene glycol diethyl ether, ethylene glycol dibutyl ether, ethylene glycol monomethyl ether acetate, ethylene glycol monoethyl ether acetate, ethylene glycol monobutyl ether acetate, ethylene glycol diacetate, diethylene glycol dimethyl ether, diethylene glycol ethyl methyl ether, diethylene glycol diethyl ether, diethylene glycol butyl methyl ether, diethylene glycol dibutyl ether, diethylene glycol monomethyl ether acetate, diethylene glycol monoethyl ether acetate, diethylene glycol monobutyl ether acetate, diethylene glycol diacetate, triethylene glycol dimethyl ether, triethylene glycol diethyl ether, triethylene glycol dibutyl ether, triethylene glycol butyl methyl ether, triethylene glycol monomethyl ether acetate, triethylene glycol monoethyl ether acetate, triethylene glycol monobutyl ether acetate, triethylene glycol diacetate, tetraethylene glycol dimethyl ether, tetraethylene glycol diethyl ether, tetraethylene glycol dibutyl ether, tetraethylene glycol monomethyl ether acetate, tetraethylene glycol monoethyl ether acetate, tetraethylene glycol monobutyl ether acetate, tetraethylene glycol diacetate, propylene glycol dimethyl ether, propylene glycol diethyl ether, propylene glycol dibutyl ether, propylene glycol monomethyl ether acetate, propylene glycol monoethyl ether acetate, propylene glycol monobutyl ether acetate, propylene glycol diacetate, dipropylene glycol dimethyl ether, dipropylene glycol methyl propyl ether, dipropylene glycol diethyl ether, dipropylene glycol dibutyl ether, dipropylene glycol monomethyl ether acetate, dipropylene glycol monoethyl ether acetate, dipropylene glycol monobutyl ether acetate, dipropylene glycol diacetate, tripropylene glycol dimethyl ether, tripropylene glycol diethyl ether, tripropylene glycol dibutyl ether, tripropylene glycol monomethyl ether acetate, tripropylene glycol monoethyl ether acetate, tripropylene glycol monobutyl ether acetate, tripropylene glycol diacetate, tetrapropylene glycol dimethyl ether, tetrapropylene glycol monomethyl ether acetate, tetrapropylene glycol diacetate, butylene glycol dimethyl ether, butylene glycol monomethyl ether acetate, butylene glycol diacetate, glycerin triacetate, 3-methoxybutyl acetate, 3-methyl-3-methoxybutyl acetate, and 3-methyl-3-methoxybutyl propionate.

Examples of the above-described nitrogen atom-containing solvent not having an N-H group include N,N-dimethylacetamide, N-methyl-2-pyrrolidone, N-ethyl-2-pyrrolidone, N-propyl-2-pyrrolidone, 1,3-dimethyl-2-imidazolidinone, 1,3-diethyl-2-imidazolidinone, 1,3-diisopropyl-2-imidazolidinone, triethylamine, and pyridine.

Examples of the above-described silicone solvent include hexamethyldisiloxane, octamethyltrisiloxane, decamethyltetrasiloxane, and dodecamethylpentasiloxane.

From the viewpoint of cost and solubility, a derivative of polyhydric alcohol (however, those having no OH group in the molecule) are preferable, and for example, at least one selected from the group consisting of diethylene glycol monoethyl ether acetate, ethylene glycol monomethyl ether acetate, propylene glycol monomethyl ether acetate, diethylene glycol dimethyl ether, diethylene glycol ethyl methyl ether, diethylene glycol diethyl ether, diethylene glycol monomethyl ether acetate, diethylene glycol diacetate, triethylene glycol dimethyl ether, ethylene glycol diacetate, ethylene glycol dimethyl ether, 3-methoxy-3-methyl-1-butyl acetate, propylene glycol dimethyl ether, propylene glycol diethyl ether, propylene glycol dibutyl ether, propylene glycol monoethyl ether acetate, propylene glycol monobutyl ether acetate, propylene glycol diacetate, dipropylene glycol dimethyl ether, dipropylene glycol methyl propyl ether, dipropylene glycol diethyl ether, dipropylene glycol dibutyl ether, dipropylene glycol monomethyl ether acetate, dipropylene glycol monoethyl ether acetate, dipropylene glycol monobutyl ether acetate, and dipropylene glycol diacetate is preferable. In addition, propylene carbonate, a linear or branched hydrocarbon solvent having 6 to 12 carbon atoms, p-menthane, diphenylmenthane, limonene, terpinene, bornane, norbornane, pinane, or the like is also preferable.

In addition, suitable examples of the aprotic solvent to be combined with the above-described suitable specific example of the silylating agent include those including one or two or more selected from the group consisting of propylene carbonate, a linear hydrocarbon-based solvent having 7 to 10 carbon atoms, menthane, pinane, γ-butyrolactone, propylene glycol monomethyl ether acetate, and 3-methoxy-3-methyl-1-butyl acetate. The composition for film formation according to the present disclosure further contains the above-described catalytic compound.

It is desirable that the composition for film formation does not contain water substantially. In addition, a film-forming composition substantially containing no water, which is obtained by not adding water at the time of preparing the composition for film formation or by using a raw material of each component containing no water or having a low water content, is more preferable. By using such a composition for film formation, the water repellency imparting effect is easily exhibited even in a case of coming into contact with or being mixed with the protic liquid.

The above-described composition for film formation can contain other components in addition to the above-described components, as long as the above-mentioned object of the present disclosure is not impaired. Examples of other components include oxidizing agents such as hydrogen peroxide and ozone, surfactants, and antioxidants such as BHT.

As one embodiment of the above-described composition for film formation, it is preferable that the composition has a formulation in which a highly reactive by-product is generated by coming into contact with the protic liquid. In a case where the by-product as described above has high reactivity with the protic liquid, it is presumed that decomposition of the silylating agent or the catalytic compound by the protic liquid is less likely to proceed, and as a result, it is considered that the decrease in water contact angle of the water-repellent film is easily suppressed. In addition, a by-product which easily reacts with a base material and contributes to the water repellency imparting effect by the reaction with the base material is also preferable.

Examples of such a highly reactive by-product include a trialkylsilylamine and a dialkylsilylamine.

The composition for film formation according to the present embodiment is obtained by mixing and dissolving each of the above-mentioned components. The obtained mixed solution (that is, the solution) may be purified using an adsorbent, a filter, or the like as necessary. In addition, each of the components may be purified in advance by distillation, and then purified using an adsorbent, a filter, or the like.

The embodiments of the present disclosure have been described above, but these are only examples of the present disclosure and various configurations other than the above can be adopted. In addition, the present disclosure is not limited to the above-described embodiments, and modifications, improvements, and the like within the range in which the object of the present disclosure can be achieved are included in the present disclosure.

### Examples

Hereinafter, the present disclosure will be described in detail with reference to Examples, but the present disclosure is not limited to the description of Examples.

### <Preparation of composition for film formation>

### (Composition 1 for film formation)

1,1,1,3,3,3-hexamethyldisilazane (raw material 1) and trifluoroacetic acid (raw material 2) were dissolved in propylene glycol monomethyl ether acetate (solvent) to obtain a composition 1 for film formation containing a silylating agent and a catalytic compound shown in Table 1.

### (Compositions 2 to 45 for film formation)

Compositions 2 to 45 for film formation were prepared by the same method as that for the composition 1 for film formation described above, except that the raw materials and mixing ratios thereof were used as described in Table 1.

### [Table 1]

**Table 1**

| | | Raw material | | | Formulation in composition | | Content in composition (% by mass) | | | |
|---|---|---|---|---|---|---|---|---|---|---|
| | | Raw material 1 | Raw material 2 | Solvent | Silylating agent | Catalytic compound | Silylating agent X | Catalytic compound Y | X + Y | X/Y |
| Example 1 | Composition 1 for film formation | HMDS | TFA | PGMEA | HMDS | TMSTFA | 12.2 | 4.6 | 16.8 | 2.7 |
| Example 2 | Composition 2 for film formation | HMDS | TFA | PGMEA | HMDS | TMSTFA | 9.1 | 2.6 | 11.7 | 3.5 |
| Example 3 | Composition 3 for film formation | HMDS | TFA | PGMEA | HMDS | TMSTFA | 7.4 | 2.6 | 10.0 | 2.8 |
| Example 4 | Composition 4 for film formation | HMDS | TMSTFA | PGMEA | HMDS | TMSTFA | 10.4 | 4.1 | 14.5 | 2.5 |
| Example 5 | Composition 5 for film formation | HMDS | TMSTFA | PGMEA | HMDS | TMSTFA | 9.4 | 3.4 | 12.8 | 2.8 |
| Example 6 | Composition 6 for film formation | HMDS | TFAA | PGMEA | HMDS | TMSTFA | 9.1 | 2.8 | 12.0 | 3.2 |
| Example 7 | Composition 7 for film formation | HMDS | TFAA | PGMEA | HMDS | TMSTFA | 7.3 | 1.1 | 8.4 | 6.6 |
| Example 8 | Composition 8 for film formation | HMDS | TFAA | PGMEA | HMDS | TMSTFA | 5.5 | 1.7 | 7.2 | 3.2 |
| Example 9 | Composition 9 for film formation | HMDS | TMSTFSA | PGMEA | HMDS | TMSTFSA | 8.6 | 3.2 | 11.8 | 2.7 |
| Example 10 | Composition 10 for film formation | HMDS | DMSTFA | PGMEA | HMDS | DMSTFA | 8.2 | 1.8 | 10.0 | 4.6 |
| Example 11 | Composition 11 for film formation | HMDS | TMSTFA | PGMEA | HMDS | TMSTFA | 8.5 | 9.3 | 17.8 | 0.9 |
| Example 12 | Composition 12 for film formation | HMDS | TFSA | PGMEA | HMDS | TMSTFSA | 7.8 | 2.8 | 10.6 | 2.8 |
| Example 13 | Composition 13 for film formation | HMDS | TFSAA | PGMEA | HMDS | TMSTFSA | 8.2 | 3.1 | 11.3 | 2.6 |
| Example 14 | Composition 14 for film formation | HMDS | MSA | PGMEA | HMDS | TMSMSA | 8.1 | 3.3 | 11.4 | 2.5 |
| Example 15 | Composition 15 for film formation | TMSDMA | TFA | PGMEA | TMSDMA | TMSTFA | 8.3 | 3.2 | 11.5 | 2.6 |
| Example 16 | Composition 16 for film formation | TMSDMA | TFAA | PGMEA | TMSDMA | TMSTFA | 8.4 | 2.2 | 10.6 | 3.8 |
| Example 17 | Composition 17 for film formation | TMSDMA | TMSTFA | PGMEA | TMSDMA | TMSTFA | 7.4 | 2.6 | 10.0 | 2.8 |
| Example 18 | Composition 18 for film formation | TMSDMA | TFSA | PGMEA | TMSDMA | TMSTFSA | 8.1 | 2.4 | 10.5 | 3.4 |
| Example 19 | Composition 19 for film formation | HMDS | TFAcIm | PGMEA | HMDS | TFAcIm | 7.7 | 2.5 | 10.2 | 3.1 |
| Example 20 | Composition 20 for film formation | HMDS | Tet | PGMEA | HMDS | Tet | 8.2 | 3.0 | 11.2 | 2.7 |
| Example 21 | Composition 21 for film formation | HMDS | Tri | PGMEA | HMDS | Tri | 7.5 | 1.9 | 9.4 | 3.9 |
| Example 22 | Composition 22 for film formation | HMDS | Tri | PGMEA | HMDS | Tri | 9.1 | 6.5 | 15.6 | 1.4 |
| Example 23 | Composition 23 for film formation | HMDS | 5-MeTet | PGMEA | HMDS | 5-MeTet | 8.7 | 2.7 | 11.4 | 3.2 |
| Example 24 | Composition 24 for film formation | MSTFA | 5-MeTet | PGMEA | MSTFA | 5-MeTet | 7.6 | 2.8 | 10.4 | 2.7 2.9 |
| Example 25 | Composition 25 for film formation | HMDS | N-MeIm | PGMEA | HMDS | N-MeIm | 7.7 | 2.7 | 10.4 | |
| Example 26 | Composition 26 for film formation | MSTFA | 4-MeIm | PGMEA | MSTFA | 4-MeIm | 7.6 | 2.9 | 10.5 | 2.6 |
| Example 27 | Composition 27 for film formation | BSMA | TMSTFA | PGMEA | BSMA | TMSTFA | 7.8 | 2.9 | 10.7 | 2.7 |
| Example 28 | Composition 28 for film formation | BDMADMS | TMSTFA | PGMEA | BDMADMS | TMSTFA | 7.9 | 2.1 | 10.0 | 3.8 |
| Example 29 | Composition 29 for film formation | TDACP | TMSTFA | PGMEA | TDACP | TMSTFA | 8.4 | 2.7 | 11.1 | 3.1 |
| Example 30 | Composition 30 for film formation | MSTFA | N-MeIm | PGMEA | MSTFA | N-MeIm | 7.8 | 2.4 | 10.2 | 3.3 |
| Example 31 | Composition 31 for film formation | MSTFA | AIm | PGMEA | MSTFA | AIm | 8.1 | 3.2 | 11.3 | 2.5 |
| Example 32 | Composition 32 for film formation | MSTFA | TMS-Im | PGMEA | MSTFA | TMS-Im | 8.4 | 2.5 | 10.9 | 3.4 |
| Example 33 | Composition 33 for film formation | TMSTFA | N-MeIm | PGMEA | TMSTFA | N-MeIm | 8.2 | 2.4 | 10.6 | 3.4 |
| Example 34 | Composition 34 for film formation | TMSTFA | TMS-Im | PGMEA | TMSTFA | TMS-Im | 8.6 | 2.4 | 11.0 | 3.6 |
| Example 35 | Composition 35 for film formation | BSTFA | 5-MeTet | PGMEA | BSTFA | 5-MeTet | 8.4 | 2.2 | 10.6 | 3.8 |
| Comparative Example 1 | Composition 36 for film formation | HMDS | TFA | PGMEA | HMDS | TMSTFA | 9.6 | 0.5 | 10.1 | 19.2 |
| Comparative Example 2 | Composition 37 for film formation | HMDS | TMSTFA | PGMEA | HMDS | TMSTFA | 9.6 | 0.5 | 10.1 | 19.2 |
| Comparative Example 3 | Composition 38 for film formation | HMDS | TFAA | PGMEA | HMDS | TMSTFA | 9.6 | 0.5 | 10.1 | 19.2 |
| Comparative Example 4 | Composition 39 for film formation | TMSDMA | Im | PGMEA | TMSDMA | TMS-Im | 6.3 | 0.5 | 6.8 | 12.6 |
| Comparative Example 5 | Composition 40 for film formation | HMDS | N-MeIm | PGMEA | HMDS | N-MeIm | 2.4 | 0.3 | 2.7 | 8.1 |
| Comparative Example 6 | Composition 41 for film formation | HMDS | Tet | PGMEA | HMDS | Tet | 8.7 | 0.5 | 9.2 | 17.4 |
| Comparative Example 7 | Composition 42 for film formation | HMDS | Im | PGMEA | HMDS | TMS-Im | 4.4 | 0.3 | 4.7 | 14.5 |
| Comparative Example 8 | Composition 43 for film formation | HMDS | Tri | PGMEA | HMDS | Tri | 9.6 | 0.6 | 10.2 | 16.0 |
| Comparative Example 9 | Composition 44 for film formation | HMDS | TFA | Decane | HMDS | TMSTFA | 5.1 | 0.6 | 5.7 | 8.5 |
| Comparative Example 10 | Composition 45 for film formation | HMDS | TFAA | iAE | HMDS | TMSTFA | 5.1 | 0.5 | 5.6 | 10.2 |

| | | | | | | | | | | |
|---|---|---|---|---|---|---|---|---|---|---|
| In Table 1, the following abbreviations are used. 4-MeIm: 4-methylimidazole 5-MeTet: 5-methyltetrazole AIm: 1-allylimidazole BDMADMS: bis(dimethylamino)dimethylsilane BSTFA: N,O-bis(trimethylsilyl)trifluoroacetamide BSMA: heptamethyldisilazane DMSTFA: dimethylsilyl trifluoroacetate HMDS: 1,1,1,3,3,3-hexamethyldisilazane iAE: isoamyl ether Im: imidazole MSA: methanesulfonic acid MSTFA: N-methyl-N-trimethylsilyl trifluoroacetamide N-MeIm: N-methylimidazole PGMEA: propylene glycol monomethyl ether acetate TDACP: 2,2,5,5-tetramethyl-2,5-disila-1-azacyclopentane Tet: 1H-tetrazole TFA: trifluoroacetic acid TFAA: trifluoroacetic acid anhydride TFAcIm: 1-(trifluoroacetyl)imidazole TFSA: trifluoromethanesulfonic acid TFSAA: trifluoromethanesulfonic acid anhydride TMS-Im: trimethylsilyl imidazole TMSDMA: N-(trimethylsilyl)dimethylamine TMSDFA: trimethylsilyl difluoropropionate TMSMSA: trimethylsilyl methanesulfonate TMSTFA: trimethylsilyl trifluoroacetate TMSTSFA: trimethylsilyl trifluoromethanesulfonate Tri: 1,2,4-triazole | | | | | | | | | | |

### <Content of each component in composition>

As for the contents of the silylating agent and the catalytic compound in the composition for film formation, values obtained by the following method were used.

In the composition for film formation used in Examples and Comparative Examples of the present application, the raw materials may react with each other during the preparation, and the formulation of the obtained composition for film formation may be different from the blending ratio of the raw materials. Therefore, first, gas chromatography (manufactured by Shimadzu Corporation, GC-2010 gas chromatography, equipped with a FID detector) was used to obtain chromatography of the obtained composition for film formation.

Next, an area fraction of the silylating agent and the catalytic compound in the measured chromatography was converted into the content of each component in the composition for film formation. A coefficient for converting the area fraction into the content was calculated by measuring a solution with a known content, which was obtained by dissolving the silylating agent or the catalytic compound in a solvent of the composition for film formation, by the gas chromatography.

The obtained composition for film formation was evaluated for the following evaluation items.

### <Evaluation of in-plane uniformity of water contact angle by wafer test>

Using the obtained composition for film formation, the water contact angle from the center to the end portion (edge) of a silicon wafer in which the protic liquid had been held on the surface, when the silicon wafer was spin-treated, was measured at predetermined intervals as follows.

First, a circular silicon wafer having a diameter of 200 mm and a thickness of 0.75 mm and having a thermal oxide film (silicon oxide film) formed on the surface with a thickness of 1 um was prepared. The following evaluation was performed by regarding the surface on which the thermal oxide film was formed as "main surface".

The silicon wafer was immersed in 1% by mass hydrofluoric acid at room temperature and cleaned.

While rotating the cleaned silicon wafer at 500 rpm with the thermally oxidized film surface facing upward, 2-propanol was supplied to the center of the wafer at a flow rate of 150 mL/min for 30 seconds while blowing nitrogen gas at a flow rate of 10 L/min (in terms of standard state) substantially vertically to the center of the wafer.

Thereafter, the supply of 2-propanol was stopped while maintaining the rotation and the blowing of the nitrogen gas, and the above-described composition for film formation was supplied to the center of the wafer at a flow rate of 70 mL/min for 15 seconds.

Thereafter, the supply of the composition for film formation was stopped while maintaining the rotation and the blowing of the nitrogen gas, and 2-propanol was supplied to the center of the wafer at a flow rate of 150 mL/min for 60 seconds.

Thereafter, the supply of 2-propanol was stopped while maintaining the blowing of the nitrogen gas, the rotation was changed to 1,000 rpm, and the state was maintained for 60 seconds.

Thereafter, the blowing of the nitrogen gas and the rotation were stopped.

The water contact angle was measured at four points at distances of 2 cm, 4 cm, 6 cm, and 8 cm from the center to the edge of the silicon wafer, and the data at each distance were averaged to obtain the distribution of the water contact angles in the radial direction. The difference between the maximum value and the minimum value among the four points was defined as the variation in water contact angle.

The results are shown in Table 2.

### <Evaluation of water contact angle by coupon test>

### (Preparation of evaluation solution)

The obtained composition for film formation was used as it was as an evaluation solution 1.

Each composition for film formation and 2-propanol were mixed with each other for 10 seconds at a mass ratio of 100:2 to prepare an evaluation solution 2.

Each composition for film formation and 2-propanol were mixed with each other for 10 seconds at a mass ratio of 100:5 to prepare an evaluation solution 3.

Using each of the evaluation solutions 1 to 3, the water contact angle on a surface of a coupon was measured as follows.

### (Measurement of water contact angle)

First, a silicon wafer having no concave-convex pattern on a surface and having a silicon oxide film with a thickness of 1 um on the surface was cut to prepare a plurality of coupons (test pieces) consisting of a silicon substrate having dimensions of a length of 4 cm, a width of 1 cm, and a thickness of 0.75 mm. The following evaluation was performed by regarding the surface on which the silicon oxide film was formed as "main surface".

The obtained coupon was immersed in 1% by mass hydrofluoric acid at room temperature for 10 minutes, immersed in ion-exchanged water four times at room temperature for 20 seconds, immersed in 2-propanol two times at room temperature for 20 seconds, and then immersed in propylene glycol monomethyl ether acetate two times at room temperature for 20 seconds to be cleaned.

The cleaned coupon was immersed in any of the evaluation solutions 1 to 3 prepared above at room temperature for 20 seconds.

Each of the coupons taken out from the evaluation solutions 1 to 3 was cleaned by repeating the immersion in 2-propanol at room temperature for 20 seconds three times, and then the surface of each coupon was dried with nitrogen gas.

Under a state in which each dried coupon was placed on a horizontal plane, 2 pl of pure water was placed on the surface of each coupon on which the silicon oxide film had formed, at room temperature, and an angle (water contact angle) formed by the water droplet and the surface of the coupon was measured in accordance with JIS R 3257:1999 using a contact angle meter (manufactured by Kyowa Interface Science Co., Ltd.; CA-X type).

The water contact angles of the evaluation solutions 1 to 3 were each set to CA0, CA2, and CA5, and the values thereof are shown in Table 2.

The water repellency imparting effect in a case of treating the surface of the silicon substrate not covered with the protic liquid with the composition for film formation can be evaluated by the CA0, and the water repellency imparting effect in a case of treating the surface of the silicon substrate covered with a predetermined amount of the protic liquid with the composition for film formation can be evaluated by the CA2 and the CA5.

### [Table 2]

**Table 2**

| | | Wafer test: water contact angle (°) | | | Coupon test: water contact angle (°) | | | | | |
|---|---|---|---|---|---|---|---|---|---|---|
| | | Maximum | Minimum | Variation | CA0 | CA2 | CA5 | CA0 - CA2 | CA0 - CA5 | CA2 - CA5 |
| Example 1 | Composition 1 for film formation | 91 | 89 | 2 | 91 | 92 | 91 | -1 | 0 | 1 |
| Example 2 | Composition 2 for film formation | 89 | 87 | 2 | 90 | 89 | 88 | 1 | 2 | 1 |
| Example 3 | Composition 3 for film formation | 89 | 87 | 2 | 89 | 88 | 87 | 1 | 2 | 1 |
| Example 4 | Composition 4 for film formation | 91 | 89 | 2 | 91 | 89 | 88 | 2 | 3 | 1 |
| Example 5 | Composition 5 for film formation | 88 | 84 | 4 | 89 | 88 | 85 | 1 | 4 | 3 |
| Example 6 | Composition 6 for film formation | 92 | 91 | 1 | 91 | 92 | 91 | -1 | 0 | 1 |
| Example 7 | Composition 7 for film formation | 90 | 88 | 2 | 90 | 91 | 72 | -1 | 18 | 19 |
| Example 8 | Composition 8 for film formation | 89 | 87 | 2 | 90 | 91 | 69 | -1 | 21 | 22 |
| Example 9 | Composition 9 for film formation | 81 | 79 | 2 | 87 | 87 | 85 | 0 | 2 | 2 |
| Example 10 | Composition 10 for film formation | 82 | 79 | 3 | 87 | 86 | 85 | 1 | 2 | 1 |
| Example 11 | Composition 11 for film formation | 85 | 80 | 5 | 85 | 80 | 74 | 5 | 11 | 6 |
| Example 12 | Composition 12 for film formation | 86 | 84 | 2 | 86 | 85 | 82 | 1 | 4 | 3 |
| Example 13 | Composition 13 for film formation | 85 | 83 | 2 | 87 | 86 | 84 | 1 | 3 | 2 |
| Example 14 | Composition 14 for film formation | 86 | 84 | 2 | 88 | 86 | 83 | 2 | 5 | 3 |
| Example 15 | Composition 15 for film formation | 87 | 84 | 3 | 91 | 90 | 89 | 1 | 2 | 1 |
| Example 16 | Composition 16 for film formation | 90 | 88 | 2 | 91 | 89 | 86 | 2 | 5 | 3 |
| Example 17 | Composition 17 for film formation | 89 | 86 | 3 | 90 | 89 | 87 | 1 | 3 | 2 |
| Example 18 | Composition 18 for film formation | 83 | 80 | 3 | 87 | 86 | 85 | 1 | 2 | 1 |
| Example 19 | Composition 19 for film formation | 82 | 79 | 3 | 83 | 80 | 76 | 3 | 7 | 4 |
| Example 20 | Composition 20 for film formation | 91 | 90 | 1 | 92 | 88 | 79 | 4 | 13 | 9 |
| Example 21 | Composition 21 for film formation | 90 | 85 | 5 | 88 | 89 | 65 | -1 | 23 | 24 |
| Example 22 | Composition 22 for film formation | 91 | 88 | 3 | 91 | 90 | 72 | 1 | 19 | 18 |
| Example 23 | Composition 23 for film formation | 86 | 82 | 4 | 86 | 82 | 71 | 4 | 15 | 11 |
| Example 24 | Composition 24 for film formation | 89 | 86 | 3 | 89 | 86 | 82 | 3 | 7 | 4 |
| Example 25 | Composition 25 for film formation | 82 | 80 | 2 | 83 | 82 | 79 | 1 | 4 | 3 |
| Example 26 | Composition 26 for film formation | 84 | 80 | 4 | 85 | 80 | 69 | 5 | 16 | 11 |
| Example 27 | Composition 27 for film formation | 86 | 84 | 2 | 87 | 84 | 80 | 3 | 7 | 4 |
| Example 28 | Composition 28 for film formation | 89 | 85 | 4 | 90 | 87 | 81 | 3 | 9 | 6 |
| Example 29 | Composition 29 for film formation | 90 | 87 | 3 | 91 | 88 | 83 | 3 | 8 | 5 |
| Example 30 | Composition 30 for film formation | 92 | 90 | 2 | 94 | 91 | 85 | 3 | 9 | 6 |
| Example 31 | Composition 31 for film formation | 95 | 93 | 2 | 96 | 94 | 89 | 2 | 7 | 5 |
| Example 32 | Composition 32 for film formation | 84 | 80 | 4 | 85 | 81 | 69 | 4 | 16 | 12 |
| Example 33 | Composition 33 for film formation | 80 | 77 | 3 | 88 | 86 | 75 | 2 | 13 | 11 |
| Example 34 | Composition 34 for film formation | 91 | 90 | 1 | 92 | 90 | 80 | 2 | 12 | 10 |
| Example 35 | Composition 35 for film formation | 81 | 77 | 4 | 82 | 80 | 74 | 2 | 8 | 6 |
| Comparative Example 1 | Composition 36 for film formation | 90 | 79 | 11 | 90 | 81 | 60 | 9 | 30 | 21 |
| Comparative Example 2 | Composition 37 for film formation | 89 | 79 | 10 | 89 | 87 | 62 | 2 | 27 | 25 |
| Comparative Example 3 | Composition 38 for film formation | 89 | 80 | 9 | 88 | 79 | 65 | 9 | 23 | 14 |
| Comparative Example 4 | Composition 39 for film formation | 68 | 58 | 10 | 70 | 62 | 51 | 8 | 19 | 11 |
| Comparative Example 5 | Composition 40 for film formation | 58 | 49 | 9 | 60 | 55 | 46 | 5 | 14 | 9 |
| Comparative Example 6 | Composition 41 for film formation | 84 | 76 | 8 | 86 | 75 | 61 | 11 | 25 | 14 |
| Comparative Example 7 | Composition 42 for film formation | 64 | 51 | 13 | 65 | 58 | 49 | 7 | 16 | 9 |
| Comparative Example 8 | Composition 43 for film formation | 70 | 58 | 12 | 83 | 59 | 51 | 24 | 32 | 8 |
| Comparative Example 9 | Composition 44 for film formation | 83 | 73 | 10 | 84 | 71 | 60 | 13 | 24 | 11 |
| Comparative Example 10 | Composition 45 for film formation | 85 | 77 | 8 | 87 | 73 | 62 | 14 | 25 | 11 |

From the above, because the compositions for film formation of Examples 1 to 35 had smaller variation in water contact angle and more excellent in-plane uniformity of the water contact angle than Comparative Examples 1 to 10 in which the content of the catalytic compound in the composition for film formation was small, the compositions for film formation of Examples 1 to 35 showed the results (excellent water repellency imparting effect) of suppressing the decrease in water contact angle of the water-repellent film in a case where the composition for film formation was supplied to a substrate in a state in which the surface was covered with a protic liquid. In any of Examples 1 to 35 and Comparative Examples 1 to 10, the water contact angle at the measurement point farthest from the center of the silicon wafer was the lowest.

In all of Examples 1 to 35, the water contact angle CA2 was 80° or more, and the decrease in water contact angle could be suppressed even in a case of adding 2% by mass of the protic liquid (2-propanol; IPA) externally.

In addition, in Examples 1 to 6, 9, 10, and 15 to 18, CA5 was 85° or more and CA2 - CA5 was 4° or less, and even in a case where the added IPA was increased to some extent, the initial water contact angle without IPA added was maintained, and the decrease in water contact angle was suppressed until the added limit amount was exceeded. The reason for such a behavior is not clear, but it is presumed that a highly reactive by-product (for example, TMS-NH₂ in a case where the catalytic compound was TMSTFA, TMSTFSA, or DMSTFA) was generated in the composition for film formation, and thus the decomposition of the silylating agent or the catalyst compound by IPA was less likely to proceed. In addition, particularly in Examples 1 to 6 and 15 to 17, it is considered that, even in a case where TMSTFA of the catalytic compound was decomposed with the IPA, the decomposed TMSTFA could react with by-products and return to TMSTFA.

It can be expected that the composition for film formation of each of Examples described above can suppress the pattern collapse on the surface of the substrate covered with the protic liquid, and thus the composition for film formation can be suitably used as a chemical solution for suppressing the pattern collapse on the surface of the base material.

Using the composition for film formation of Example 1 described above, the water contact angle (°) of CA0 was measured under the same conditions as in <Evaluation of water contact angle by coupon test> described above, using a silicon wafer having a surface on which "silicon oxide film" and "tungsten film" had been formed. As a result, it was found that the water contact angle in the "silicon oxide film" was larger than the water contact angle in the "tungsten film".

From the result, it was suggested that the composition for film formation of each of Examples can be suitably used to form a selective protective film.

Priority is claimed on Japanese Patent Application No. 2021-213908, filed December 28, 2021, the disclosure of which is incorporated herein by reference.

### REFERENCE SIGNS LIST

10 substrate
12 main surface
20 concave-convex structure
22 convex portion
24 concave portion
30 protic liquid
60 composition for film formation
70 water-repellent film

## Claims

1. A composition for film formation, which is used for forming a water-repellent film on at least a part of a surface of a substrate by being supplied to the substrate, in which the surface is covered with a protic liquid, the composition comprising:
a silylating agent which silylates the surface of the substrate;
a catalytic compound which promotes a silylation reaction by the silylating agent; and
an aprotic solvent,
wherein a content of the catalytic compound is 1.0% by mass or more with respect to 100% by mass of the composition for film formation.

2. The composition for film formation according to Claim 1,
wherein a water contact angle CA2 in a case of adding 2% by mass of 2-propanol, which is measured by the following coupon test, is 80° or more,
(procedure of coupon test)
a silicon wafer having no concave-convex pattern on a surface and having a silicon oxide film with a thickness of 1 um on the surface is cut to prepare a coupon consisting of a silicon substrate having dimensions of a length of 4 cm, a width of 1 cm, and a thickness of 0.75 mm,
the coupon is immersed in 1% by mass hydrofluoric acid at a room temperature, immersed in water four times at the room temperature, immersed in 2-propanol two times at the room temperature, and immersed in propylene glycol monomethyl ether acetate two times at the room temperature to be cleaned,
an evaluation solution obtained by mixing the composition for film formation and 2-propanol in an amount of 2% by mass or 5% by mass with respect to 100% by mass of the composition for film formation in terms of mass is prepared, and the cleaned coupon is immersed in the evaluation solution at the room temperature,
the coupon extracted from the evaluation solution is cleaned by being immersed in 2-propanol three times at the room temperature, and a surface of the coupon is dried with nitrogen gas,
in a state in which the dried coupon is placed on a horizontal plane, 2 pl of pure water is placed on the surface of the coupon on which the silicon oxide film has formed, at the room temperature, and a water contact angle (°) is measured in accordance with JIS R 3257:1999, and
a water contact angle of the evaluation solution in which the 2% by mass or 5% by mass of 2-propanol has been added is indicated as CA2 or CA5, respectively.

3. The composition for film formation according to Claim 2,
wherein a water contact angle CA5 in a case of adding 5% by mass of 2-propanol, which is measured by the above coupon test, is 80° or more.

4. The composition for film formation according to any one of Claims 1 to 3,
wherein, in a case where, with respect to 100% by mass of the composition for film formation, a content of the silylating agent is denoted by X in terms of mass and a content of the catalytic compound is denoted by Y in terms of mass, X and Y satisfy 1.0 < X/Y ≤ 20.

5. The composition for film formation according to any one of Claims 1 to 4,
wherein a content of the catalytic compound is 30% by mass or less with respect to 100% by mass of the composition for film formation.

6. The composition for film formation according to any one of Claims 1 to 5,
wherein the silylating agent contains a silicon compound represented by General Formula [1],
R¹ₐSi(H)_{b}X_{4-a-b} [1]
(in General Formula [1], R¹'s are each independently an organic group including a hydrocarbon group having 1 to 18 carbon atoms, in which a part or all of hydrogen atoms may be replaced with fluorine atoms, X's are each independently a monovalent organic group in which an atom bonded to an Si atom is nitrogen, oxygen, carbon, or halogen, a is an integer of 1 to 3, b is an integer of 0 to 2, and a sum of a and b is 1 to 3).

7. The composition for film formation according to any one of Claims 1 to 6,
wherein the catalytic compound includes one or two or more selected from the group consisting of trimethylsilyl trifluoroacetate, trimethylsilyl trifluoromethanesulfonate, dimethylsilyl trifluoroacetate, dimethylsilyl trifluoromethanesulfonate, butyldimethylsilyl trifluoroacetate, butyldimethylsilyl trifluoromethanesulfonate, hexyldimethylsilyl trifluoroacetate, hexyldimethylsilyl trifluoromethanesulfonate, octyldimethylsilyl trifluoroacetate, octyldimethylsilyl trifluoromethanesulfonate, decyldimethylsilyl trifluoroacetate, and decyldimethylsilyl trifluoromethanesulfonate.

8. The composition for film formation according to any one of Claims 1 to 6,
wherein the catalytic compound includes one or two or more selected from the group consisting of trimethylsilyl trifluoroacetate, dimethylsilyl trifluoroacetate, butyldimethylsilyl trifluoroacetate, hexyldimethylsilyl trifluoroacetate, octyldimethylsilyl trifluoroacetate, and decyldimethylsilyl trifluoroacetate.

9. The composition for film formation according to any one of Claims 1 to 6,
wherein the catalytic compound includes one or two or more selected from the group consisting of trimethylsilyl trifluoromethanesulfonate, dimethylsilyl trifluoromethanesulfonate, butyldimethylsilyl trifluoromethanesulfonate, hexyldimethylsilyl trifluoromethanesulfonate, octyldimethylsilyl trifluoromethanesulfonate, and decyldimethylsilyl trifluoromethanesulfonate.

10. The composition for film formation according to any one of Claims 1 to 6,
wherein the catalytic compound includes one or two or more selected from the group consisting of a compound having a guanidine skeleton, a nitrogen-containing heterocyclic compound containing no silicon atom, and a silylated heterocyclic compound.

11. The composition for film formation according to any one of Claims 1 to 10,
wherein a total content of the silylating agent and the catalytic compound contained in 100% by mass of the composition for film formation is 8% by mass or more.

12. A method for manufacturing a substrate, comprising:
a step of preparing a substrate having a concave-convex pattern on a surface;
a step of supplying a protic liquid to the surface of the substrate; and
a step of supplying a composition for film formation to the surface holding the protic liquid to form a water-repellent film on at least a part of the surface,
wherein the composition for film formation contains a silylating agent which silylates the surface of the substrate, a catalytic compound which promotes a silylation reaction by the silylating agent, and an aprotic solvent, and
a content of the catalytic compound is 1.0% by mass or more with respect to 100% by mass of the composition for film formation.

13. The method for manufacturing a substrate according to Claim 12,
wherein the step of forming the water-repellent film includes a step of forming a mixed liquid obtained by mixing the protic liquid held on the substrate and the composition for film formation supplied to the substrate.
